# EUROPEAN PATENT SPECIFICATION

(11) **EP 4 625 819 B1**
(45) Date of publication and mention of the grant of the patent: **09.09.2026**
(21) Application number: 24215076.1
(22) Date of filing: 25.11.2024
(51) Int. Cl.: H03K 17/0412

(54) **SEMICONDUCTOR DEVICE**
HALBLEITERANORDNUNG
DISPOSITIF SEMI-CONDUCTEUR

(30) Priority: 29.03.2024 KR 20240043498
(43) Date of publication of application: 01.10.2025
(73) Proprietor: Samsung Electronics Co., Ltd., Suwon-si, Gyeonggi-do 16677 (KR)
(72) Inventor: PARK, Junhyuk, Suwon-si, Gyeonggi-do 16677 (KR); HWANG, In Jun, Suwon-si, Gyeonggi-do 16677 (KR)
(74) Representative: Kuhnen & Wacker Patent- und Rechtsanwaltsbüro PartG mbB

(56) References cited:
- US-A1- 2022 045 683

## Description

### (a) Technical Field

The present disclosure is directed to semiconductor devices.

### (b) Discussion of Related Art

In modern society, semiconductor devices are closely related to daily life. In particular, the importance of power semiconductor devices used in transportation fields such as electric vehicles, railroads, and electric trams; and renewable energy systems such as solar power generation and wind power generation, and mobile devices is gradually increasing. Power semiconductor devices are semiconductor devices used to handle high voltage or high current, and perform functions such as power conversion and control in large power systems or high-output electronic devices. Power semiconductor devices have the ability and durability to handle high power, so they can handle large amounts of current and withstand high voltage. For example, power semiconductor devices can handle voltages from hundreds of volts to thousands of volts and currents from tens of amperes to thousands of amperes. Power semiconductor devices can increase the efficiency of electrical energy by minimizing power loss. Additionally, power semiconductor devices can be stably driven even in environments such as high temperatures.

Examples of these power semiconductor devices include Silicon Carbide (SiC) power semiconductor devices and Gallium Nitride (GaN) power semiconductor devices. Power semiconductor devices may be manufactured using SiC or GaN instead of existing silicon wafers to compensate for unstable characteristics at high temperatures. The SiC power semiconductor devices are resistant to high temperatures and have low power loss, and may be suitable for electric vehicles, renewable energy systems, etc. The GaN power semiconductor devices are expensive to manufacture, but are efficient in terms of speed and can be suitable for high-speed charging of mobile devices.

However, SiC and GaN power semiconductor devices may suffer from leakage current, which may reduce their performance.

US 2022/045683 A1 discloses the following: A semiconductor device using unipolar transistors, in which high and low levels are expressed using high and low power supply potentials, is provided. The semiconductor device includes four transistors, two capacitors, two wirings, two input terminals, and an output terminal. A source or a drain of the first transistor and a source or a drain of the fourth transistor are electrically connected to the first wiring. A gate of the fourth transistor is electrically connected to the first input terminal, and a gate of the second transistor is electrically connected to the second input terminal. A source or a drain of the second transistor and a source or a drain of the third transistor are electrically connected to the second wiring. The first transistor, the second transistor, and the two capacitors are electrically connected to the output terminal.

### SUMMARY

The scope of protection is defined by the appended claims.

One aspect of the present disclosure provides a semiconductor device in which when connecting a voltage divider for sensing voltage to a power semiconductor, even in a gallium nitride-based high electron mobility transistor (HEMT), where it is difficult to provide a high-resistance element to reduce leakage current, it is possible to distribute voltage using capacitors without a resistor, and it is possible to prevent voltage shift due to leakage current by preventing a voltage output circuit of the voltage diver from floating.

A semiconductor device according to an embodiment includes a power semiconductor including a main transistor and a voltage divider. The voltage divider is connected to the power semiconductor and includes a plurality of capacitors, a voltage output circuit connected between the plurality of capacitors, and a reset transistor connected to the voltage output circuit. A gate electrode of the main transistor is connected to a gate electrode of the reset transistor.

A semiconductor device according to an embodiment includes a power semiconductor located in a main device region and including a main transistor; and a voltage divider. The voltage divider is located in a peripheral circuit region located on one side of the main device region, is connected to the power semiconductor, and includes a plurality of capacitors, a voltage output circuit connected between the plurality of capacitors, and a reset transistor connected to the voltage output circuit. The main transistor includes a main channel layer, a main barrier layer on the main channel layer, a main gate electrode on the main barrier layer, and a main source electrode and a main drain electrode which are connected to the main channel layer. The reset transistor includes a reset channel layer spaced apart from the main channel layer, a reset barrier layer on the reset channel layer, a reset gate electrode on the reset barrier layer, and a first reset electrode and a second reset electrode which are connected to the reset channel layer. The main gate electrode and the reset gate electrode are connected to each other.

A semiconductor device may further include a main channel layer, a main barrier layer on the main channel layer, a main gate electrode on the main barrier layer, and a main source electrode and a main drain electrode which are connected to the main channel layer. The reset transistor includes a reset channel layer spaced apart from the main channel layer in a second direction different from the first direction by a separation pattern extending in the first direction, a reset barrier layer on the reset channel layer, a reset gate electrode located on the reset barrier layer and connected to the main gate electrode, a first reset electrode connected to the reset channel layer and connected to the main source electrode, and a second reset electrode connected to the reset channel layer.

In the semiconductor device according to embodiments, when connecting a voltage divider for sensing voltage to a power semiconductor, even in gallium nitride-based high electron mobility transistors, where it is difficult to provide high-resistance elements to reduce leakage current, it is possible to distribute the voltage using the voltage using capacitors without a resistor, and voltage shift due to leakage can be prevented by preventing a voltage output from floating.

### BRIEF DESCRIPTION OF THE DRAWINGS

FIG. 1 is a circuit diagram of a semiconductor device according to an embodiment.
FIGS. 2 to 4 are plan views showing a semiconductor device according to an embodiment.
FIG. 5 is a cross-sectional view taken along line I1-I1' in FIG. 4.
FIG. 6 is a cross-sectional view taken along line I2-I2' of FIG. 4.
FIGS. 7 to 10 are plan views showing a semiconductor device according to an embodiment.
FIG. 11 is a cross-sectional view taken along line I4-I4' of FIG. 10.
FIG. 12 is a cross-sectional view taken along line I5-I5' of FIG. 10.
FIG. 13 is a cross-sectional view taken along line I6-I6' of FIG. 10.

### DETAILED DESCRIPTION

Hereinafter, the present disclosure will be described more fully hereinafter with reference to the accompanying drawings, in which example embodiments of the present disclosure are shown. However, the described embodiments may be modified in various different ways, all without departing from the scope of the present disclosure.

The drawings and description are to be regarded as illustrative in nature and not restrictive. Like reference numerals designate like elements throughout the specification.

It will be understood that when an element such as a layer, film, region, or substrate is referred to as being "on" another element, it can be directly on the other element or intervening elements may also be present.

In addition, in this specification, the phrase "on a plane" means viewing a target portion from the top, and the phrase "on a cross-section" means viewing a cross-section formed by vertically cutting a target portion from the side.

In addition, throughout the specification, two directions parallel to and intersecting the upper surface of the substrate are defined as the first direction D1 and the second direction D2, respectively, and the direction perpendicular to the upper surface of the substrate is described as the third direction D3. For example, the first direction D1 and the second direction D2 may be perpendicular to each other.

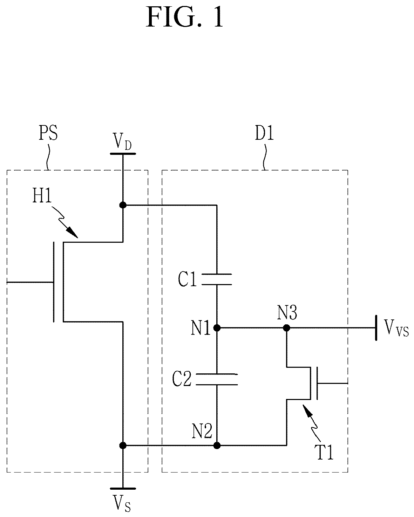

FIG. 1 is a circuit diagram of a semiconductor device according to an embodiment.

Referring to FIG. 1, the semiconductor device includes a power semiconductor PS and a voltage divider D1 connected to the power semiconductor PS.

The power semiconductor PS includes a main transistor H1. As an example, the main transistor H1 may be a gallium nitride-based high electron mobility transistor (HEMT).

As an example, the main transistor H1 may include a main gate electrode, a main drain electrode, and a main source electrode. The main transistor H1 can control the drain-source current between the main drain electrode and the main source electrode according to a gate signal applied to the main gate electrode.

A first power voltage V_{D} may be supplied to the main drain electrode, and a second power voltage Vs may be supplied to the main source electrode. In an embodiment, a size, magnitude or amplitude of the second power voltage Vs is smaller than a size, magnitude or amplitude of the first power voltage V_{D}. For example, the second power voltage Vs may be a ground voltage.

The voltage divider D1 includes a plurality of capacitors C1 and C2, a voltage output unit Vᵥₛ (e.g., a voltage output circuit) connected between the plurality of capacitors C1 and C2, and a reset transistor T1 connected to the voltage output unit Vᵥₛ.

As an example, the plurality of capacitors C1 and C2 may include a first capacitor C1 and a second capacitor C2 connected in series with each other.

In an embodiment, one end of the first capacitor C1 is connected to one end of the main transistor H1. For example, one end of the first capacitor C1 may be connected to the main drain electrode of the main transistor H1. Accordingly, the first power voltage V_{D} may be supplied to one end of the first capacitor C1. In this embodiment, additionally, the other end of the first capacitor C1 may be connected to the voltage output unit Vᵥₛ through the first node N1.

In an embodiment, one end of the second capacitor C2 is connected to the voltage output unit Vᵥₛ through the first node N1. In this embodiment, additionally, one end of the second capacitor C2 may be connected to the other end of the first capacitor C1 through the first node N1. The other end of the second capacitor C2 may be connected to the other end of the main transistor H1 through the second node N2. For example, one end of the second capacitor C2 may be connected to the main source electrode of the main transistor H1. Accordingly, the second power voltage Vs may be supplied to one end of the second capacitor C2.

In an embodiment, the second capacitor C2 may have a larger capacitance than the first capacitor C1. That is, the capacitance of the second capacitor C2 connected to the main source electrode of the main transistor H1 may be larger than that of the first capacitor C1 connected to the main drain electrode of the main transistor H1. For example, the first capacitor C1 may include a thick Inter-Metal-Dielectric (IMD) layer to withstand high voltage, and the second capacitor C2 may have a metal-insulator-metal (MIM) structure including a thin dielectric layer to ensure that the second capacitor C2 has a large capacitance. The capacitance of the first capacitor C1 and the second capacitor C2 can be adjusted by the length and width of the metal wire and the thickness of the dielectric.

The voltage divider D1 uses resistors connected between the main drain electrode and the main source electrode to prevent a leakage current. On the other hand, in a circuit where a voltage divider for voltage sensing is connected to a power semiconductor, a voltage divider using a resistor generates a leakage current corresponding to V_{D}/R_{Total}, where R_{Total} is the resistance of the resistors. However, to bring the leakage current down to 100 µA or less, a very high resistance of 4 MΩ (400V/100µA) or higher is required. For example, to obtain a high resistance of about 600 Ω, it is necessary to increase the aspect ratio of the resistor to about 6700 or more, but in this case, a problem of parasitic inductance occurs. Accordingly, when the main transistor H1 is a gallium nitride-based high electron mobility transistor (HEMT), it is difficult to provide such a high-resistance device.

To solve this problem, the voltage divider D1 consisting of capacitors without a resistor is used. However, when the voltage divider D1 is configured in this manner, the voltage output unit Vᵥₛ may float and a voltage shift due to leakage current may occur.

Accordingly, in the semiconductor device according to an embodiment, the voltage divider D1 further includes a reset transistor T1. The reset transistor T1 is connected to the voltage output unit Vᵥₛ. As an example, the reset transistor T1 may include a reset gate electrode, a first reset electrode, and a second reset electrode. In an embodiment, the main gate electrode of the main transistor H1 and the reset gate electrode of the reset transistor T1 are connected. That is, by connecting the reset gate electrode of the reset transistor T1 to the main gate electrode of the main transistor H1, the charge accumulated in the voltage output unit Vᵥₛ during a turn-on operation escapes through the main source electrode of the main transistor H1, and thus it is automatically reset to 0 V or Vs, and the voltage can be distributed to V_{D}C₁/(C₁+C₂) during a turn-off operation. In this way, since the voltage output unit Vᵥₛ is not floating, voltage shift due to leakage current can be prevented.

The first reset electrode of the reset transistor T1 may be connected to the main source electrode of the main transistor H1. Accordingly, the second power voltage Vs may be supplied to one end of the second capacitor C2. For example, the second power voltage Vs may be a ground voltage. For example, the first reset electrode of the reset transistor T1 may be connected to the other end of the second capacitor C2 through the second node N2.

The second reset electrode of the reset transistor T1 may be connected to the voltage output unit Vᵥₛ. For example, the second reset electrode may be connected to the voltage output unit Vᵥₛ through the third node N3. In addition, the second reset electrode is connected to the first node N1 through the third node N3, and accordingly, the second reset electrode may be connected to the other end of the first capacitor C1 and one end of the second capacitor C2 through the first node N1.

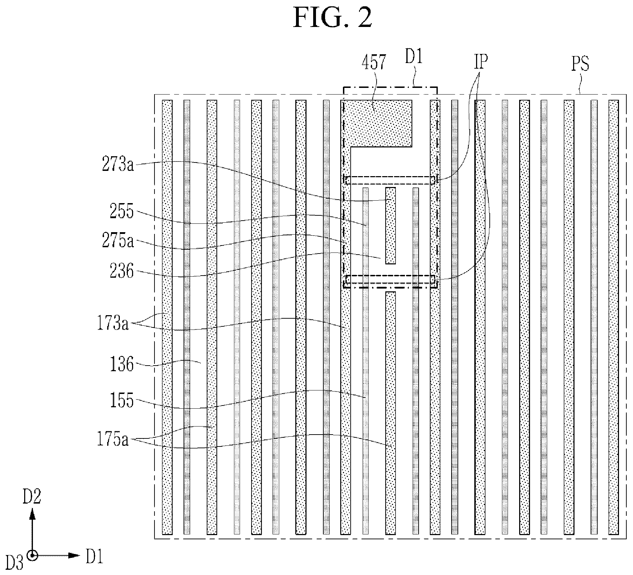

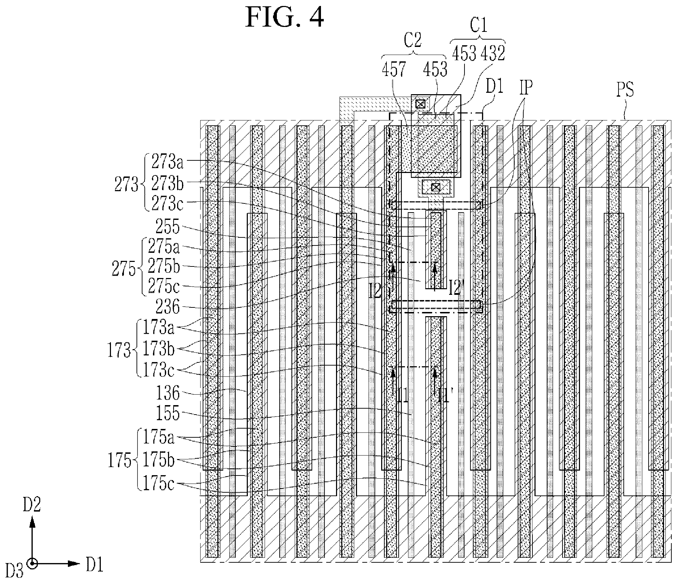

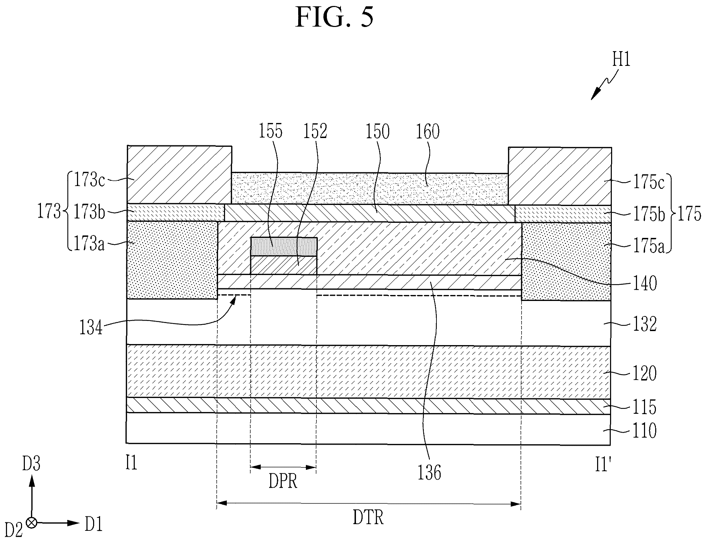

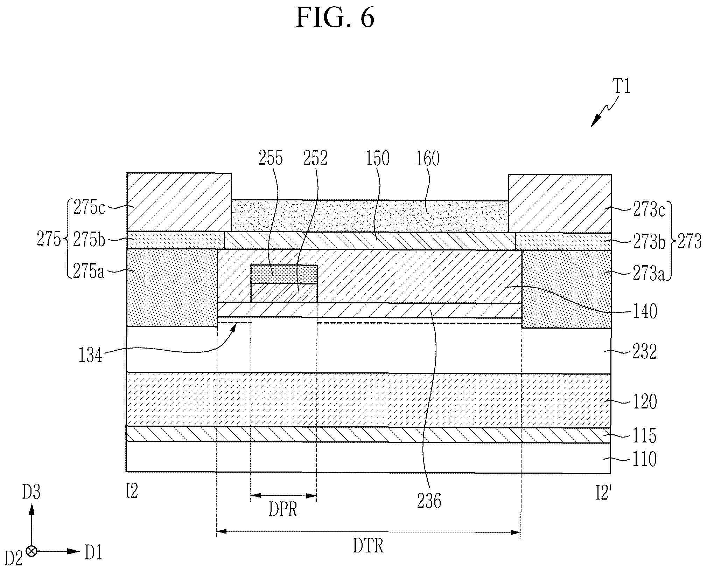

FIGS. 2 to 4 are plan views showing a semiconductor device according to an embodiment. FIG. 5 is a cross-sectional view taken along line I1-I1' in FIG. 4. FIG. 6 is a cross-sectional view taken along line I2-I2' of FIG. 4.

For clear understanding and simplified illustration, FIG. 2 mainly shows the main barrier layer 136, the main gate electrode 155, the lower main source electrode 173a, and the lower main drain electrode 175a of the power semiconductor PS and the reset barrier layer 236, the reset gate electrode 255, the lower first reset electrode 275a, the lower second reset electrode 273a, and the third capacitor electrode 457 of the voltage divider D1.

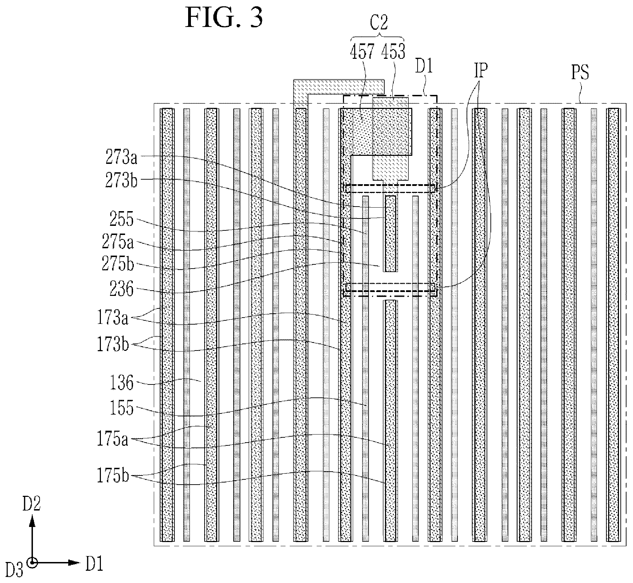

FIG. 3 mainly shows the middle main source electrode 173b and the middle main drain electrode 175b of the power semiconductor PS, and the middle first reset electrode 275b, the middle second reset electrode 273b, and the second capacitor electrode 453 of the voltage divider D1.

FIG. 4 mainly shows the upper main source electrode 173c and the upper main drain electrode 175c of the power semiconductor PS, and the upper first reset electrode 275c, the upper second reset electrode 273c, and the third capacitor electrode 432 of the voltage divider D1.

Referring to FIGS. 1 and 2 to 6, the semiconductor device may include a power semiconductor PS and a voltage divider D1 connected to the power semiconductor PS.

For example, the power semiconductor PS may be located in the main device region, and the voltage divider D1 may be located in a peripheral circuit region located around the main device region. As an example, the power semiconductor PS and the voltage divider D1 may be located together on one substrate. The power semiconductor PS and the voltage divider D1 may be arranged to be spaced apart in the second direction D2 with the separation pattern IP interposed therebetween. That is, the positions of the power semiconductor PS and the voltage divider D1 on the substrate 110 may be defined by the separation pattern IP.

The power semiconductor PS may include a main transistor H1. As an example, the main transistor H1 may be a gallium nitride-based high electron mobility transistor (HEMT). The voltage divider D1 may include a plurality of capacitors C1 and C2, a voltage output unit Vᵥₛ connected between the plurality of capacitors C1 and C2, and a reset transistor T1 connected to the voltage output unit Vᵥₛ.

As an example, the main transistor H1, the reset transistor T1, and the plurality of capacitors C1 and C2 may be arranged to be spaced apart in the second direction D2 by the separation pattern IP. In an embodiment, the separation pattern IP is located between the main channel layer 132 and the reset channel layer 232. The separation pattern IP may extend along the first direction D1. For example, the separation pattern IP may extend along the first direction D1 from the bottom of the main source electrode 173 through the bottom of the main gate electrode 155 to the bottom of the main drain electrode 175. Alternatively, the separation pattern IP may extend along the first direction D1 from the bottom of the first reset electrode 275 through the bottom of the reset gate electrode 255 to the bottom of the second reset electrode 273.

There may be a plurality of separation patterns IP, and the plurality of separation patterns IP may be spaced apart from one another in the second direction D2. In an embodiment, the reset transistor T1 is located between the plurality of spaced apart separation patterns IP, and on one side of the reset transistor T1 in the second direction D2, a main transistor H1 is provided beyond a position in which the separation pattern IP is located, and on the other side, the first and second capacitors C1 and C2 may be located beyond a position of the separation pattern IP.

The separation pattern IP can be formed by injecting a material such as Argon (Ar) using an ion implantation (IIP) method while a channel material layer is formed on the buffer layer.

Additionally, the reset transistor T1 and the plurality of capacitors C1 and C2 may be located between the main transistor H1 in the first direction D1. For example, the reset transistor T1 and the plurality of capacitors C1 and C2 may be located between one main source electrode 173 and the other main source electrode 173 of the main transistor H1. In addition, the reset transistor T1 and the plurality of capacitors C1 and C2 may be arranged to be spaced apart from the main drain electrode 175 between one main source electrode 173 and the other main source electrode 173 of the main transistor H1 by the separation pattern IP in the second direction D2.

As shown in FIG. 5, the main transistor H1 may include a main channel layer 132, a main barrier layer 136 on the main channel layer 132, a main gate electrode 155 on the main barrier layer 136, and a main source electrode 173 and a main drain electrode 175 that are spaced apart from the main gate electrode 155.

The main channel layer 132 is a layer that forms a channel between the main source electrode 173 and the main drain electrode 175 and a two-dimensional electron gas (2DEG) 134 may be located inside the main channel layer 132. The two-dimensional electron gas 134 refers to a group of electrons that can move freely in two dimensions (e.g., in an x-y plane direction) as a charge transport model used in solid-state physics, but cannot move and are tightly bound in another dimension (e.g., in a z direction). In other words, the two-dimensional electron gas 134 may exist in a two-dimensional sheet-line form within a three-dimensional space. This two-dimensional electron gas 134 may be present in a semiconductor heterojunction structure, and may occur at the interface between the main channel layer 132 and the main barrier layer 136 in the main transistor H1 according to an embodiment. For example, the two-dimensional electron gas 134 may be generated in the portion closest to the main barrier layer 136 within the main channel layer 132.

The main channel layer 132 may include one or more materials selected from Group III-V materials, for example, nitrides including at least one of Aluminum (AI), Gallium (Ga), Indium (In), and Boron (B). The main channel layer 132 may be made of a single layer or multiple layers. The main channel layer 132 may be AlₓIn_{y}Ga_{1-x-y}N (0≤x≤1, 0≤y≤1, x+y≤1). For example, the main channel layer 132 may include at least one of Aluminum Nitride (AIN), Gallium Nitride (GaN), Indium Nitride (InN), Indium Gallium Nitride (InGaN), Aluminum Gallium Nitride (AlGaN), Aluminum Indium Nitride (AlInN), and Aluminum Indium Gallium Nitride (AlInGaN). The main channel layer 132 may be a layer doped with impurities or a layer undoped with impurities. A thickness of the main channel layer 132 may be about several hundred nanometer (nm) or less.

The main channel layer 132 may be located on the substrate 110, and a seed layer 115, a buffer layer 120, etc. may be located between the substrate 110 and the main channel layer 132. The substrate 110, the seed layer 115, and the buffer layer 120 may be omitted in some cases. For example, when a substrate made of GaN is used as the main channel layer 132, at least one of the substrate 110, the seed layer 115, and the buffer layer 120 may be omitted. Considering that the price of a substrate made of GaN is relatively high, the main channel layer 132 including GaN can be grown using the substrate 110 made of Si. As the lattice structure of Si and GaN are different, it may not be easy to grow the main channel layer 132 directly on the substrate 110. Accordingly, the seed layer 115 and the buffer layer 120 can be first grown on the substrate 110, and then the main channel layer 132 can be grown on the buffer layer 120. Additionally, at least one of the substrate 110, the seed layer 115, and the buffer layer 120 may be removed from the final structure of the main transistor H1 after being used in the manufacturing process.

The substrate 110 may include a semiconductor material. For example, the substrate 110 may include sapphire, Si, SiC, AIN, GaN, or a combination thereof. In an embodiment, the substrate 110 is a silicon on insulator (SOI) substrate. However, the material of the substrate 110 is not limited to this, and any commonly used substrate can be applied. In some cases, the substrate 110 may include an insulating material. For example, several layers, including the main channel layer 132, may be first formed on a semiconductor substrate, then the semiconductor substrate may be removed and replaced with an insulating substrate.

The seed layer 115 may be located on the substrate 110. The seed layer 115 may be located directly on the substrate 110. However, embodiments are not limited to this, and another predetermined layer may be further located between the substrate 110 and the seed layer 115. The seed layer 115 is a layer that serves as a seed for growing the buffer layer 120, and may be made of a crystal lattice structure that serves as a seed for the buffer layer 120. For example, the seed layer 115 may include AlN, but is not limited thereto.

The buffer layer 120 may be located on the seed layer 115. The buffer layer 120 may be located directly on the seed layer 115. However, embodiments are not limited to this, and another predetermined layer may be further located between the seed layer 115 and the buffer layer 120. The buffer layer 120 may be located between the seed layer 115 and the main channel layer 132. The buffer layer 120 may include one or more materials selected from Group III-V materials, for example, nitrides including at least one of Al, Ga, In, and B. The buffer layer 120 may be AlₓIn_{y}Ga_{1-x-y}N (0≤x≤1, 0≤y≤1, x+y≤1). For example, the buffer layer 120 may include at least one of AIN, GaN, InN, InGaN, AlGaN, AlInN, and AlinGaN. The buffer layer 120 may be made of a single layer or multiple layers. For example, the buffer layer 120 may include a superlattice layer and a high-resistance layer.

The superlattice layer alleviates a difference in lattice constant and thermal expansion coefficient between the substrate 110 and the main channel layer 132, thereby relieving tensile stress and compressive stress generated between the substrate 110 and the main channel layer 132. In an embodiment, the high-resistance layer may be used to prevent the main transistor H1 from being deteriorated by preventing leakage current from flowing through the main channel layer 132. To this end, the high-resistance layer may be made of a low-conductivity material to electrically insulate the substrate 110 and the main channel layer 132.

The main barrier layer 136 may be located on the main channel layer 132. The main barrier layer 136 may be located directly on the main channel layer 132. However, embodiments are not limited to this, and another predetermined layer may be further located between the main channel layer 132 and the main barrier layer 136. A region of the main channel layer 132 that is overlapped with the main barrier layer 136 may be a drift region DTR. The drift region DTR may be located between the main source electrode 173 and the main drain electrode 175. When a potential difference occurs between the main source electrode 173 and the main drain electrode 175, carriers may move in the drift region DTR. The main transistor H1 according to an embodiment may be turned on/off depending on whether a voltage is applied to the main gate electrode 155 and the magnitude of the voltage applied to the main gate electrode 155. When a voltage greater than the threshold voltage is applied to the main gate electrode 155 and the main transistor H1 is turned on, a channel may be created in the depletion region DPR. Accordingly, movement of the carrier may occur in the drift region DTR. If a voltage lower than the threshold voltage is applied to the main gate electrode 155 or no voltage is applied, the channel path may be blocked in the depletion region DPR and carrier movement may not occur.

The main barrier layer 136 may include one or more materials selected from Group III-V materials, for example, nitrides including at least one of Al, Ga, In, and B. The main barrier layer 136 may be AlₓIn_{y}Ga_{1-x-y}N (0≤x≤1, 0≤y≤1, x+y≤1). The main barrier layer 136 may include at least one of GaN, InN, AlGaN, AlInN, InGaN, AIN, or AlInGaN. An energy bandgap of the main barrier layer 136 can be adjusted by the composition ratio of Al and/or In. The main barrier layer 136 may be doped with a predetermined impurity. In an embodiment, the impurity doped into the main barrier layer 136 may be a p-type dopant that can provide holes. For example, the impurity doped into the main barrier layer 136 may be magnesium (Mg). By increasing or decreasing the impurity doping concentration of the main barrier layer 136, the threshold voltage, on-resistance, etc. of the main transistor H1 according to an embodiment can be adjusted.

In an embodiment, the main barrier layer 136 includes a semiconductor material having different characteristics from the main channel layer 132. The main barrier layer 136 may be different from the main channel layer 132 in at least one of polarization characteristics, energy bandgap, and lattice constant. For example, the main barrier layer 136 may include a material having a different energy bandgap than the main channel layer 132. In an embodiment, the main barrier layer 136 has a higher energy bandgap than the main channel layer 132 and has a higher electrical polarization rate than the main channel layer 132. The two-dimensional electron gas 134 may be induced in the main channel layer 132, which has a relatively low electrical polarization rate, by the main barrier layer 136. In this regard, the main barrier layer 136 may also be referred to as a channel supply layer or a two-dimensional electron gas supply layer. The two-dimensional electron gas 134 may be formed within the portion of the main channel layer 132 under the interface between the main channel layer 132 and the main barrier layer 136. The two-dimensional electron gas 134 may have very high electron mobility.

The main gate electrode 155 may be located on the main barrier layer 136. In an embodiment, the main gate electrode 155 overlaps with a portion of the main barrier layer 136 in a plan view. The main gate electrode 155 may be overlapped with a portion of the drift region DTR of the main channel layer 132. The main gate electrode 155 may be located between the main source electrode 173 and the main drain electrode 175. The main gate electrode 155 may be spaced apart from the main source electrode 173 and the main drain electrode 175. The main gate electrode 155 may extend along the second direction D2 on a plane. That is, the main gate electrode 155 may have a rod shape extending lengthwise along the second direction D2 on a plane.

The main gate electrode 155 may include a conductive material. For example, the main gate electrode 155 may include a metal, a metal alloy, conductive metal nitride, metal silicide, a doped semiconductor material, conductive metal oxide, or conductive metal oxynitride. For example, the main gate electrode 155 may be made of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAIN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt) , nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The main gate electrode 155 may be made of a single layer or multiple layers.

The main transistor H1 may further include a main gate semiconductor layer 152 located between the main barrier layer 136 and the main gate electrode 155. That is, the main gate semiconductor layer 152 may be located on the main barrier layer 136, and the main gate electrode 155 may be located on the main gate semiconductor layer 152. The main gate electrode 155 may be in Schottky contact with the main gate semiconductor layer 152. For example, the contact between the main gate electrode 155 and the main gate semiconductor layer 152 may form a Schottky barrier, rather than an ohmic contact. However, the present disclosure is not limited thereto, and in some cases, the main gate electrode 155 may be in ohmic contact with the main gate semiconductor layer 152. The main gate semiconductor layer 152 may overlap with the main gate electrode 155. In an embodiment, the main gate semiconductor layer 152 is completely overlapped with the main gate electrode 155 in the third direction D3. The upper surface of the main gate semiconductor layer 152 may be entirely covered by the main gate electrode 155. The main gate semiconductor layer 152 may have substantially the same planar shape as the main gate electrode 155.

The main gate semiconductor layer 152 may be located between the main source electrode 173 and the main drain electrode 175. The main gate semiconductor layer 152 may be spaced apart from the main source electrode 173 and the main drain electrode 175. In an embodiment, the main gate semiconductor layer 152 is located closer to the main source electrode 173 than the main drain electrode 175. That is, a separation distance between the main gate semiconductor layer 152 and the main source electrode 173 may be smaller than a separation distance between the main gate semiconductor layer 152 and the main drain electrode 175.

The main gate semiconductor layer 152 may include one or more materials selected from Group III-V materials, for example, nitrides including at least one of Al, Ga, In, and B. The main gate semiconductor layer 152 may be AlₓIn_{y}Ga_{1-x-y}N (0≤x≤1, 0≤y≤1, x+y≤1). For example, the main gate semiconductor layer 152 may include at least one of AlN, GaN, InN, InGaN, AlGaN, AlInN, or AlInGaN. In an embodiment, the main gate semiconductor layer 152 includes a material having a different energy bandgap than the main barrier layer 136. For example, the main gate semiconductor layer 152 may include GaN, and the main barrier layer 136 may include AlGaN. The main gate semiconductor layer 152 may be doped with a predetermined impurity. In an embodiment, the impurity doped into the main gate semiconductor layer 152 is a p-type dopant that can provide holes. For example, the main gate semiconductor layer 152 may include GaN doped with p-type impurities. That is, the main gate semiconductor layer 152 may be made of a p-GaN layer. However, embodiments are not limited to this, and the main gate semiconductor layer 152 may be a p-AlGaN layer. The impurity doped into the main gate semiconductor layer 152 may be magnesium (Mg). The main gate semiconductor layer 152 may be made of a single layer or multiple layers.

A depletion region DPR may be formed in the main channel layer 132 by the main gate semiconductor layer 152. The depletion region DPR may be located within the drift region DTR and may have a narrower width than the drift region DTR. When the main gate semiconductor layer 152 having a different energy bandgap than that of the main barrier layer 136 is located on the main barrier layer 136, a level of the energy band of a portion of the main barrier layer 136 that is overlapped with the main gate semiconductor layer 152 may increase. Accordingly, the depletion region DPR may be formed in the area of the main channel layer 132 that is overlapped with the main gate semiconductor layer 152. The depletion region DPR may be a region in the channel path of the main channel layer 132 where the two-dimensional electron gas 134 is not formed or may have a lower electron concentration than the remaining regions. That is, the depletion region DPR may refer to a region where the flow of the two-dimensional electron gas 134 is interrupted within the drift region DTR. When the depletion region DPR is generated, current does not flow between the main source electrode 173 and the main drain electrode 175, and the channel path may be blocked. Accordingly, the main transistor H1 according to an embodiment may have normally off characteristics (e.g., remain in an off state).

That is, the main transistor H1 may be a normally off main transistor H1 (HEMT, High Electron Mobility Transistor). In a normal state in which no voltage is applied to the main gate electrode 155, a depletion region DPR exists, and the main transistor H1 according to an embodiment may be in an off state. When a voltage higher than the threshold voltage is applied to the main gate electrode 155, the depletion region DPR disappears, and the two-dimensional electron gas 134 may be connected without being disconnected within the drift region DTR. That is, the two-dimensional electron gas 134 may be formed throughout the channel path between the main source electrode 173 and the main drain electrode 175, and the main transistor H1 according to an embodiment may enter an on state. In summary, the main transistor H1 may include semiconductor layers with different electrical polarization characteristics, and a semiconductor layer with a relatively high polarization rate can induce two-dimensional electron gas 134 in another semiconductor layer that forms a heterojunction therewith. This two-dimensional electron gas 134 can be used as a channel between the main source electrode 173 and the main drain electrode 175, and the continuation or interruption of the flow of the two-dimensional electron gas 134 can be controlled using a bias voltage applied to the main gate electrode 155. In the gate-off state, the flow of the two-dimensional electron gas 134 is blocked, and thus current may not flow between the main source electrode 173 and the main drain electrode 175. In the gate-on state, the two-dimensional electron gas 134 continues to flow, and thus current may flow between the main source electrode 173 and the main drain electrode 175.

Although the case where the main transistor H1 according to an embodiment is a normally off high electron mobility transistor has been described above, the present disclosure is not limited thereto. For example, the main transistor H1 according to an embodiment may be a normally-on high electron mobility transistor. In the case of a normally-on high electron mobility transistor, the main gate semiconductor layer 152 may be omitted, and accordingly, the main gate electrode 155 may be located directly on the main barrier layer 136. That is, the main gate electrode 155 may contact the main barrier layer 136. In this structure, the two-dimensional electron gas 134 can be used as a channel while no voltage is applied to the main gate electrode 155, and current may flow between the main source electrode 173 and the main drain electrode 175. Additionally, when a negative voltage is applied to the main gate electrode 155, a depletion region DPR in which the flow of the two-dimensional electron gas 134 is cut off may be generated at the bottom of the main gate electrode 155.

The buffer layer 120, the main channel layer 132, the main barrier layer 136, and the main gate semiconductor layer 152 described above may be sequentially stacked on the substrate 110. In the main transistor H1 according to an embodiment, at least one of the buffer layer 120, the main channel layer 132, the main barrier layer 136, and the main gate semiconductor layer 152 may be omitted. The buffer layer 120, the main channel layer 132, the main barrier layer 136, and the main gate semiconductor layer 152 may be made of the same semiconductor material, and considering the role of each layer and the performance required for the main transistor H1, a material composition ratio of each layer may be different.

The main transistor H1 may further include first to third protective layers 140, 150, and 160 located on the main barrier layer 136 and the main gate electrode 155. As an example, the main transistor H1 may include a first protective layer 140, a second protective layer 150 located on the first protective layer 140, and a third protective layer 160 located on the second protective layer 150. The first protective layer 140 may cover an upper surface of the main barrier layer 136 and the main gate electrode 155, and may cover side surfaces of the main gate electrode 155 and the main gate semiconductor layer 152. The lower surface of the first protective layer 140 may be in contact with the main barrier layer 136, the main gate electrode 155, and the main gate semiconductor layer 152. The upper surface of the first protective layer 140 may be in contact with the second protective layer 150. The second and third protective layers 150 and 160 may be spaced from the main barrier layer 136, the main gate electrode 155, and the main gate semiconductor layer 152 by the first protective layer 140. Accordingly, the second and third protective layers 150 and 160 need not contact the main barrier layer 136, the main gate electrode 155, and the main gate semiconductor layer 152.

The main barrier layer 136 and the main gate electrode 155 may be protected by the first to third protective layers 140, 150, and 160 and may be separated from other components. The first to third protective layers 140, 150, and 160 may include an insulating material. For example, the first to third protective layers 140, 150, and 160 may include an oxide such as SiO₂ or Al₂O₃. As another example, the first to third protective layers 140, 150, and 160 may include nitride such as SiN or oxynitride such as SiON. The first to third protective layers 140, 150, and 160 may include the same material or different materials. If the first to third protective layers 140, 150, and 160 are made of the same material, boundaries between the first to third protective layers 140, 150, and 160 may not be visible. The first to third protective layers 140, 150, and 160 may each be made of a single layer or multiple layers.

The main source electrode 173 and the main drain electrode 175 may be located on the main channel layer 132. The main source electrode 173 and the main drain electrode 175 may be spaced apart from each other, and the main gate electrode 155 and the main gate semiconductor layer 152 may be formed between the main source electrode 173 and the main drain electrode 175. The main gate electrode 155 and the main gate semiconductor layer 152 are spaced apart from the main source electrode 173 and the main drain electrode 175. The main source electrode 173 may be electrically connected to the main channel layer 132 on one side of the main gate electrode 155. The main drain electrode 175 may be electrically connected to the main channel layer 132 on the other side of the main gate electrode 155. In an embodiment, the main source electrode 173 and the main drain electrode 175 are located outside the drift region DTR of the main channel layer 132. The boundary between the main source electrode 173 and the main channel layer 132 may be one edge of the drift region DTR. Likewise, the boundary between the main drain electrode 175 and the main channel layer 132 may be the other edge of the drift region DTR. However, the present disclosure is not limited thereto. For example, the main source electrode 173 and the main drain electrode 175 need not be located outside the drift region DTR of the main channel layer 132 in other embodiments. In an embodiment, the main channel layer 132 is not recessed, and the main source electrode 173 and the main drain electrode 175 may be located on the upper surface of the main channel layer 132. The bottom surfaces of the main source electrode 173 and the main drain electrode 175 may contact the upper surface of the main channel layer 132. A portion of the main channel layer 132 in contact with the main source electrode 173 and the main drain electrode 175 may be doped at a high concentration. At this time, the carriers passing through the two-dimensional electron gas 134 may pass through the highly doped main channel layer 132, that is, may be transmitted to the main source electrode 173 and the main drain electrode 175 through the upper of the two-dimensional electron gas 134. In an embodiment, the main source electrode 173 and the main drain electrode 175 do not directly contact the two-dimensional electron gas 134 in the horizontal direction. The horizontal direction may refer to a direction parallel to the upper surface of the main channel layer 132 or the main barrier layer 136.

The main source electrode 173 and the main drain electrode 175 may extend along the second direction D2 on a plane. That is, the main source electrode 173 and the main drain electrode 175 may have a rod shape extending lengthwise along the second direction D2 on a plane. The main source electrode 173 and the main drain electrode 175 may extend in parallel directions. The main source electrode 173 and the main drain electrode 175 may extend in a direction parallel to the main gate electrode 155.

The main source electrode 173 and the main drain electrode 175 may include a conductive material. For example, the main source electrode 173 and the main drain electrode 175 may include a metal, a metal alloy, conductive metal nitride, metal silicide, a doped semiconductor material, conductive metal oxide, or conductive metal oxynitride. For example, the main source electrode 173 and the main drain electrode 175 may be made of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt) , nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium. (Rh), palladium (Pd), iridium (Ir), osmium (Os), silver (Ag), gold (Au), zinc (Zn), vanadium (V), or a combination thereof, but are not limited thereto. The main source electrode 173 and the main drain electrode 175 may be made of a single layer or multiple layers. In an embodiment, the main source electrode 173 and the main drain electrode 175 are in ohmic contact with the main channel layer 132. A region in contact with the main source electrode 173 and the main drain electrode 175 within the main channel layer 132 may be doped at a relatively high concentration compared to other regions.

The main source electrode 173 may include the lower main source electrode 173a, the middle main source electrode 173b, and the upper main source electrode 173c. The middle main source electrode 173b may be located on the lower main source electrode 173a. The upper main source electrode 173c may be located on the middle main source electrode 173b. In an embodiment, the lower main source electrode 173a is in direct contact with the main channel layer 132 and is electrically connected to the main channel layer 132. In an embodiment, the middle main source electrode 173b and the upper main source electrode 173c are not in direct contact with the main channel layer 132, and may be electrically connected to the main channel layer 132 through the lower main source electrode 173a.

The main drain electrode 175 may include the lower main drain electrode 175a, the middle main drain electrode 175b, and the upper main drain electrode 175c. The middle main drain electrode 175b may be located on the lower main drain electrode 175a. The upper main drain electrode 175c may be located on the middle main drain electrode 175b. In an embodiment, the lower main drain electrode 175a is in direct contact with the main channel layer 132 and is electrically connected to the main channel layer 132. In an embodiment, the middle main drain electrode 175b and the upper main drain electrode 175c are not in direct contact with the main channel layer 132, and may be electrically connected to the main channel layer 132 through the lower main drain electrode 175a.

The lower main source electrode 173a and the lower main drain electrode 175a may be located on the first protective layer 140. The lower main source electrode 173a and the lower main drain electrode 175a may be located between the first protective layer 140 and the second protective layer 160. The lower main source electrode 173a and the lower main drain electrode 175a penetrate the first protective layer 140 and the main barrier layer 136, and trenches recessing the upper surface of the main channel layer 132 may be located on both sides of the main gate electrode 155 to be spaced apart from each other. The lower main source electrode 173a and the lower main drain electrode 175a may be located in the trench on both sides of the main gate electrode 155, respectively. The lower main source electrode 173a and the lower main drain electrode 175a may be formed to fill the trench. Within the trench, the lower main source electrode 173a and the lower main drain electrode 175a may contact the main channel layer 132 and the main barrier layer 136. The main channel layer 132 may form the bottom and side walls of the trench, and the main barrier layer 136 may form the side walls of the trench. Accordingly, the lower main source electrode 173a and the lower main drain electrode 175a may contact an upper surface and side surfaces of the main channel layer 132. Additionally, the lower main source electrode 173a and the lower main drain electrode 175a may contact a side surface of the main barrier layer 136. That is, the lower main source electrode 173a and the lower main drain electrode 175a may cover the side surfaces of the main channel layer 132 and the main barrier layer 136. The upper surfaces of the lower main source electrode 173a and the lower main drain electrode 175a may protrude from an upper surface of the first protective layer 140. Additionally, at least one of the lower main source electrode 173a and the lower main drain electrode 175a may cover at least a portion of the upper surface of the first protective layer 140. A second protective layer 160 may be located on the lower main source electrode 173a and the lower main drain electrode 175a. At least a portion of the lower main source electrode 173a and the lower main drain electrode 175a may be covered by the second protective layer 160.

The voltage divider D1 may include a reset transistor T1 and a plurality of capacitors C1 and C2 located on one side of the reset transistor T1.

As shown in FIG. 6, the reset transistor T1 may include a reset channel layer 232, a reset barrier layer 236 on the reset channel layer 232, a reset gate electrode 255 on the reset barrier layer 236, and a first reset electrode 275 and a second reset electrode 273 located on both sides of the reset gate electrode 255.

The reset channel layer 232 may be a layer that forms a channel between the second reset electrode 273 and the first reset electrode 275. A two-dimensional electron gas 134 may be located in the reset channel layer 232. The two-dimensional electron gas 134 may be generated at the interface between the reset channel layer 232 and the reset barrier layer 236. For example, the two-dimensional electron gas 134 may be generated in the portion closest to the reset barrier layer 236 within the reset channel layer 232.

The reset channel layer 232 may be located in the same layer as the main channel layer 132 of the main transistor H1. The reset channel layer 232 may include the same material as the main channel layer 132 of the main transistor H1 and may be formed in the same process.

The reset channel layer 232 may be located on the substrate 110, and a seed layer 115 and a buffer layer 120 may be located between the substrate 110 and the reset channel layer 232. That is, the reset channel layer 232 can be formed simultaneously with the main channel layer 132 of the main transistor H1 on the same substrate 110 using the same process. That is, after forming the seed layer 115 and the buffer layer 120 on the substrate 110, the main channel layer 132 and the reset channel layer 232 can be formed on the buffer layer 120 at the same time.

In an embodiment, the main channel layer 132 and the reset channel layer 232 are spaced apart from one another in the second direction D2. The main channel layer 132 and the reset channel layer 232 may be separated from each other by the separation pattern IP. The positions of the main channel layer 132 and the reset channel layer 232 on the substrate 110 may be defined by the separation pattern IP. The separation pattern IP may be located between the main channel layer 132 and the reset channel layer 232. The separation pattern IP can be formed by injecting a material such as Ar using an ion implantation (IIP) method while a channel material layer is formed on the buffer layer 120. The main channel layer 132 and the reset channel layer 232 can be formed to be spaced apart from each other by this separation pattern IP.

The reset barrier layer 236 may be located on the reset channel layer 232. In an embodiment, the reset barrier layer 236 is located directly on the reset channel layer 232. However, the present disclosure is not limited thereto, and another layer may be further located between the reset channel layer 232 and the reset barrier layer 236. The region of the reset channel layer 232 that is overlapped with the reset barrier layer 236 may be a drift region DTR. That is, when a voltage greater than the threshold voltage is applied to the reset gate electrode 255, a channel may be generated in a region of the reset channel layer 232 that is overlapped with the reset barrier layer 236 in the third direction D3, between the second reset electrode 273 and the first reset electrode 275.

The reset barrier layer 236 may be formed simultaneously with the main barrier layer 136 of the main transistor H1 using the same process. The reset barrier layer 236 may include the same material as the main barrier layer 136. In an embodiment, the reset barrier layer 236 includes a semiconductor material having different characteristics from the reset channel layer 232. The reset barrier layer 236 may be different from the reset channel layer 232 in at least one of polarization characteristics, energy bandgap, and lattice constant. For example, the reset barrier layer 236 may include a material having a different energy bandgap than the reset channel layer 232. In an embodiment, the reset barrier layer 236 has a higher energy bandgap than the reset channel layer 232 and may have a higher electrical polarization rate than the reset channel layer 232. A two-dimensional electron gas may be formed within the portion of the reset channel layer 232 located under the interface between the reset channel layer 232 and the reset barrier layer 236.

The reset gate electrode 255 may be located on the reset barrier layer 236. In an embodiment, the reset gate electrode 255 overlaps with a portion of the reset barrier layer 236. The reset gate electrode 255 may overlap with a portion of the drift region of the reset channel layer 232. The reset gate electrode 255 may be located between the second reset electrode 273 and the first reset electrode 275. The reset gate electrode 255 may be spaced apart from the first reset electrode 275 and the second reset electrode 273. The reset gate electrode 255 may extend along the second direction D2 on a plane. That is, the reset gate electrode 255 may have a rod shape extending lengthwise along the second direction D2 on a plane.

The reset gate electrode 255 may be formed simultaneously with the main gate electrode 155 of the main transistor H1 using a same process. The reset gate electrode 255 may include the same material as the main gate electrode 155. The reset gate electrode 255 may be made of a single layer or multiple layers.

As an example, the reset gate electrode 255 may be electrically connected to the main gate electrode 155 of the main transistor H1. The reset gate electrode 255 may include the same material as the main gate electrode 155 and may be located in a same layer as the main gate electrode 155. The reset gate electrode 255 may be formed simultaneously with the main gate electrode 155 using a same process. The boundary between the reset gate electrode 255 and the main gate electrode 155 may be indistinct, and thus the reset gate electrode 255 may be formed integrally with the main gate electrode 155. For example, a same layer or integral structure may be used to form both the reset gate electrode 255 and the main gate electrode 155. The reset gate electrode 255 and the main gate electrode 155 may be distinguished from one another by a separation pattern IP therebetween.

Accordingly, the main gate electrode 155 of the main transistor H1 and the reset gate electrode 255 of the reset transistor T1 are connected. That is, by connecting the reset gate electrode 255 of the reset transistor T1 to the main gate electrode 155 of the main transistor H1, the charge accumulated in the voltage output unit Vᵥₛ during a turn-on operation escapes through the main source electrode 173 of the main transistor H1, and thus it is automatically reset to 0 V, and the voltage can be distributed to V_{D}C₁/(C₁+C₂) during a turn-off operation. In this way, since the voltage output unit Vᵥₛ is not floating, a voltage shift due to leakage current can be prevented.

The reset transistor T1 may further include a reset gate semiconductor layer 252 between the reset barrier layer 236 and the reset gate electrode 255. That is, the reset gate semiconductor layer 252 may be located on the reset barrier layer 236, and the reset gate electrode 255 may be located on the reset gate semiconductor layer 252. The reset gate electrode 255 may be in Schottky contact with the reset gate semiconductor layer 252. However, the present disclosure is not limited thereto, and in some cases, the reset gate electrode 255 may be in ohmic contact with the reset gate semiconductor layer 252. The reset gate semiconductor layer 252 may overlap with the reset gate electrode 255. In an embodiment, the reset gate semiconductor layer 252 completely overlaps with the reset gate electrode 255 in the third direction D3. The upper surface of the reset gate semiconductor layer 252 may be entirely covered by the reset gate electrode 255. The reset gate semiconductor layer 252 may have substantially the same planar shape as the reset gate electrode 255.

The reset gate semiconductor layer 252 may be located between the second reset electrode 273 and the first reset electrode 275. The reset gate semiconductor layer 252 may be spaced apart from the first reset electrode 275 and the second reset electrode 273. In an embodiment, the reset gate semiconductor layer 252 is located closer to the first reset electrode 275 than the second reset electrode 273. That is, a separation distance between the reset gate semiconductor layer 252 and the first reset electrode 275 may be smaller than a separation distance between the reset gate semiconductor layer 252 and the second reset electrode 273.

The reset gate semiconductor layer 252 may be formed simultaneously with the main gate semiconductor layer 152 using a same process. The reset gate semiconductor layer 252 may include the same material as the main gate semiconductor layer 152. The reset gate semiconductor layer 252 may be made of a single layer or multiple layers.

A depletion region DPR may be formed in the reset channel layer 232 by the reset gate semiconductor layer 252. When the depletion region DPR is generated, current does not flow between the second reset electrode 273 and the first reset electrode 275, and the channel path may be blocked. Accordingly, the reset transistor T1 according to an embodiment may have normally off characteristics. When a voltage higher than the threshold voltage is applied to the reset gate electrode 255, the depletion region disappears, and two-dimensional electron gas 134 may be formed throughout the channel path between the second reset electrode 273 and the first reset electrode 275.

The reset transistor T1 according to an embodiment may be a normally on high electron mobility transistor. That is, the reset gate semiconductor layer 252 may be omitted, and in this case, a depletion region should not be formed in the reset channel layer 232. Accordingly, the reset gate electrode 255 may be located directly on the reset barrier layer 236. That is, the reset gate electrode 255 may contact the reset barrier layer 236.

The buffer layer 120, the reset channel layer 232, the reset barrier layer 236, and the reset gate semiconductor layer 252 described above may be sequentially stacked on the substrate 110. In the reset transistor T1 according to an embodiment, at least one of the buffer layer 120, the reset channel layer 232, the reset barrier layer 236, and the reset gate semiconductor layer 252 may be omitted. The buffer layer 120, the reset channel layer 232, the reset barrier layer 236, and the reset gate semiconductor layer 252 may be made of the same semiconductor material, and considering the role of each layer and the performance required for a high electron mobility transistor, a material composition ratio of each layer may be different.

The first reset electrode 275 and the second reset electrode 273 may be located on the reset channel layer 232. The first reset electrode 275 and the second reset electrode 273 may be spaced apart from each other, and a reset gate electrode 255 and a reset gate semiconductor layer 252 may be located between the second reset electrode 273 and the first reset electrode 275. The reset gate electrode 255 and the reset gate semiconductor layer 252 may be spaced apart from the first reset electrode 275 and the second reset electrode 273. The second reset electrode 273 may be electrically connected to the reset channel layer 232 on one side of the reset gate electrode 255 and may be connected to the voltage output unit Vᵥₛ. The first reset electrode 275 may be electrically connected to the reset channel layer 232 on the other side of the reset gate electrode 255.

A drift region DTR as described with reference to FIG. 5 may be located in a partial area of the reset channel layer 232 between the second reset electrode 273 and the first reset electrode 275. In an embodiment, the first reset electrode 275 and the second reset electrode 273 are located outside the drift region of the reset channel layer 232. That is, the first reset electrode 275 and the second reset electrode 273 extend into the reset channel layer 232, and a portion of the side surface may be in contact with the reset channel layer 232. The drift region may be located between a portion of the side surface of the second reset electrode 273 in contact with the reset channel layer 232 and a portion of the side surface of the first reset electrode 275 in contact with the reset channel layer 232. However, the present disclosure is not limited thereto. For example, the first reset electrode 275 and the second reset electrode 273 may not be located outside the drift region DTR of the reset channel layer 232 in other embodiments. In an embodiment, the reset channel layer 232 is not recessed, and the first reset electrode 275 and the second reset electrode 273 may be located on the upper surface of the reset channel layer 232. The bottom surfaces of the first reset electrode 275 and the second reset electrode 273 may contact the upper surface of the main channel layer 132. A portion of the main channel layer 132 in contact with the first reset electrode 275 and the second reset electrode 273 may be doped at a high concentration.

The first reset electrode 275 and the second reset electrode 273 may extend along the second direction D2 on a plane. That is, the first reset electrode 275 and the second reset electrode 273 may have a rod shape extending lengthwise along the second direction D2 on a plane. The second reset electrode 273 and the first reset electrode 275 may extend in parallel directions. The first reset electrode 275 and the second reset electrode 273 may extend in a direction parallel to the reset gate electrode 255.

The first reset electrode 275 and the second reset electrode 273 may be in ohmic contact with the reset channel layer 232. A region in the reset channel layer 232 that is in contact with the first reset electrode 275 and the second reset electrode 273 may be doped at a relatively high concentration compared to other regions.

Meanwhile, the first reset electrode 275 may be located parallel to the main source electrode 173 of the main transistor H1 in the second direction D2, and may be located in a same line or column as one of the main source electrodes 173 in the second direction D2.

Additionally, the first reset electrode 275 may be electrically connected to one main source electrode 173. The first reset electrode 275 may include the same material as the main source electrode 173 and may be located in a same layer as the main source electrode 173. The first reset electrode 275 may be formed simultaneously with the main source electrode 173 using a same process, and the first reset electrode 275 may be formed integrally with the main source electrode 173. For example, a single layer or structure may be used to form the first reset electrode 275 and the main source electrode 173.

As an example, a separation pattern IP may be located at the lower portion between the first reset electrode 275 and the main source electrode 173, and the first reset electrode 275 and the main source electrode 173 located in a same line or column may be distinguished by a separation pattern IP.

In an embodiment, one end of the separation pattern IP is located at the lower portion between the first reset electrode 275 and the main source electrode 173, wherein one end of the separation pattern IP passes through one side of the first reset electrode 275 on a plane (e.g., FIG. 4) but does not pass through the other side, and one end of the separation pattern IP may be located within a width direction region of the first reset electrode 275. In other words, the separation pattern IP does not extend in the first direction D1 until it completely passes through the first reset electrode 275, but one end of the separation pattern IP may extend to be located at about half the width of the first reset electrode 275 in the first direction D1, so that one side through which the separation pattern IP passes is used as the first reset electrode 275 and the other side through which the separation pattern IP does not pass may be used as the main source electrode 173.

The second reset electrode 273 may be located parallel to the main drain electrode 175 of the main transistor H1 in the second direction D2, and may be located in a same line or column as one of the main drain electrodes 175 in the second direction D2.

The second reset electrode 273 may include the same material as the main drain electrode 175 and may be located in a same layer as the main drain electrode 175. The second reset electrode 273 may be formed simultaneously with the main drain electrode 175 using a same process. However, the second reset electrode 273 is not electrically connected to the main drain electrode 175. As an example, a separation pattern IP may be located between the second reset electrode 273 and the main drain electrode 175, and the second reset electrode 273 and the main drain electrode 175 may be spaced apart with a separation pattern IP therebetween.

The first reset electrode 275 may include a lower first reset electrode 275a, a middle first reset electrode 275b, and an upper first reset electrode 275c. The middle first reset electrode 275b may be located on the lower first reset electrode 275a. The upper first reset electrode 275c may be located on the middle first reset electrode 275b. In an embodiment, the lower first reset electrode 275a is in direct contact with the reset channel layer 232 and may be electrically connected to the reset channel layer 232. The middle first reset electrode 275b and the upper first reset electrode 275c may not be in direct contact with the reset channel layer 232, and may be electrically connected to the reset channel layer 232 through the lower first reset electrode 275a.

The lower first reset electrode 275a, the middle first reset electrode 275b, and the upper first reset electrode 275c may be electrically connected to the main source electrode 173. For example, the lower first reset electrode 275a, the middle first reset electrode 275b, and the upper first reset electrode 275c may be connected to each of the lower main source electrode 173a, the middle main source electrode 173b, and the upper main source electrodes 173c. The lower first reset electrode 275a, the middle first reset electrode 275b, and the upper first reset electrode 275c may include the same material as the lower main source electrode 173a, the middle main source electrode 173b, and the upper main source electrode 173c, respectively, and may be located in a same layer as the lower main source electrode 173a, the middle main source electrode 173b, and the upper main source electrode 173c.

The second reset electrode 273 may include the lower second reset electrode 273a, the middle second reset electrode 273b, and the upper second reset electrode 273c. The middle second reset electrode 273b may be located on the lower second reset electrode 273a. The upper second reset electrode 273c may be located on the middle second reset electrode 273b. In an embodiment, the lower second reset electrode 273a is in direct contact with the reset channel layer 232 and may be electrically connected to the reset channel layer 232. In an embodiment, the middle second reset electrode 273b and the upper second reset electrode 273c are not in direct contact with the reset channel layer 232, and may be electrically connected to the reset channel layer 232 through the lower second reset electrode 273a.

In an embodiment, the lower second reset electrode 273a, the middle second reset electrode 273b, and the upper second reset electrode 273c are not electrically connected to the main drain electrode 175. For example, each of the lower second reset electrode 273a, the middle second reset electrode 273b, and the upper second reset electrode 273c may be spaced apart from each of the lower main drain electrode 175a, the middle main drain electrode 175b, and the upper main drain electrodes 175c in the second direction D2. The separation pattern IP may be located between each of the lower second reset electrode 273a, the middle second reset electrode 273b, and the upper second reset electrode 273c and each of the lower main drain electrode 175a, the middle main drain electrode 175b, and the upper main drain electrode 175c.

However, each of the lower second reset electrode 273a, the middle second reset electrode 273b, and the upper second reset electrode 273c may include the same material as each of the lower main drain electrode 175a, the middle main drain electrode 175b, and the upper main drain electrode 175c, and may be located in a same layer as the lower main drain electrode 175a, the middle main drain electrode 175b, and the upper main drain electrode 175c.

The first and second capacitors C1 and C2 may be located on one side of the reset transistor T1 in the second direction D2. For example, the plurality of capacitors C1 and C2 and the reset transistor T1 may be arranged to be spaced apart in the second direction D2 by the separation pattern IP in the peripheral circuit region. In other words, the separation pattern IP may be located between the plurality of capacitors C1 and C2 and the reset transistor T1.

As an example, the first capacitor C1 includes a first capacitor electrode 432, a first dielectric under the first capacitor electrode 432, and a second capacitor electrode 453 under the first dielectric.

In addition, the second capacitor C2 may include a second capacitor electrode 453, a second dielectric under the second capacitor electrode 453, and a third capacitor electrode 457 under the second dielectric.

The first capacitor electrode 432 may be one electrode of the first capacitor C1. As an example, the first capacitor electrode 432 may include a same material as the upper second reset electrode 273c of the second reset electrode 273 and may be located in a same layer as the upper second reset electrode 273c. The first capacitor electrode 432 may be formed simultaneously with the upper second reset electrode 273c using a same process. However, the first capacitor electrode 432 and the upper second reset electrode 273c may be spaced apart with the separation pattern IP therebetween.

The first capacitor electrode 432 may be electrically connected to the main drain electrode 175 of the main transistor H1. For example, the middle main drain electrode 175b of one of the main drain electrodes 175 located spaced apart from the first capacitor electrode 432 in the first direction D1 extends in the first direction D1 and the second direction D2 so that one end may be located under the third direction D3 of the first capacitor electrode 432, and may be connected to the first capacitor electrode 432 through the first contact hole CH1 penetrating the first capacitor electrode 432 in the third direction D3.

The second capacitor electrode 453 may be a common electrode of the first capacitor C1 and the second capacitor C2. That is, the second capacitor electrode 453 may be both one electrode of the first capacitor C1 and one electrode of the second capacitor C1.

The second capacitor electrode 453 may be electrically connected to the second reset electrode 273 of the reset transistor T1. As an example, the second capacitor electrode 453 may include a same material as the middle second reset electrode 273b of the second reset electrode 273 and may be located in a same layer as the middle second reset electrode 273b. The second capacitor electrode 453 may be formed simultaneously with the middle second reset electrode 273b using a same process, and the second capacitor electrode 453 may be formed integrally with the middle second reset electrode 273b. For example, the second capacitor electrode 453 and the middle second reset electrode 273b may be connected beyond the separation pattern IP located below between them.

Additionally, the second capacitor electrode 453 may be electrically connected to the voltage output unit Vᵥₛ. For example, the second capacitor electrode 453 may be connected to the voltage output unit Vᵥₛ through the second contact hole CH2 penetrating the first protective layer 140 in the thickness direction. For example, the second contact hole CH2 may be located in a connection portion between the second capacitor electrode 453 and the middle second reset electrode 273b.

Accordingly, one end of the first capacitor C1 may be connected to the main drain electrode 175, and the other end may be connected to the second reset electrode 273.

The third capacitor electrode 457 may be one electrode of the second capacitor C2. The third capacitor electrode 457 may be electrically connected to the lower first reset electrode 275a. The third capacitor electrode 457 may include a same material as the lower first reset electrode 275a and may be located in a same layer as the lower first reset electrode 275a. The third capacitor electrode 457 may be formed simultaneously with the lower first reset electrode 275a using a same process, and the third capacitor electrode 457 may be formed integrally with the lower first reset electrode 275a.

For example, a separation pattern IP may be located between the third capacitor electrode 457 and the lower first reset electrode 275a, and the third capacitor electrode 457 and the lower first reset electrode 275a may be distinguished from one another by the separation pattern IP.

In an embodiment, one end of the separation pattern IP is located at the lower portion between the third capacitor electrode 457 and the lower first reset electrode 275a, wherein one end of the separation pattern IP passes through one side of the lower first reset electrode 275a on a plane (e.g., FIG. 4) but does not pass through the other side, and one end of the separation pattern IP may be located within the width direction region of the lower first reset electrode 275a. In other words, the separation pattern IP does not extend in the first direction D1 until it completely passes through the lower first reset electrode 275a, but one end of the separation pattern IP may extend to be located at about half the width of the first reset electrode 275 in the first direction D1, so that one side through which the separation pattern IP passes is used as the first reset electrode 275 and the other side through which the separation pattern IP does not pass may be used as the main source electrode 173.

The first to third capacitor electrodes 432, 453, and 457 may include a conductive material. For example, the first to third capacitor electrodes 432, 453, and 457 may include a metal, a metal alloy, conductive metal nitride, metal silicide, a doped semiconductor material, conductive metal oxide, or conductive metal oxynitride. For example, the first to third capacitor electrodes 432, 453, and 457 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlIN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt) , nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium. (Rh), palladium (Pd), iridium (Ir), osmium (Os), silver (Ag), gold (Au), zinc (Zn), vanadium (V), or a combination thereof, but are not limited thereto. The first to third capacitor electrodes 432, 453, and 457 may be made of a single layer or multiple layers.

The first and second dielectrics may include an insulating material. In an embodiment, the first and second dielectrics may be SiN_{X} (0<x≤2). However, the first and second dielectrics are not limited thereto, and may include various types of insulating materials that can insulate the first to third capacitor electrodes 432, 453, and 457. For example, the first and second dielectrics may include an insulating material such as SiO₂, Al₂O₃, SiN, or SiON, or a combination thereof.

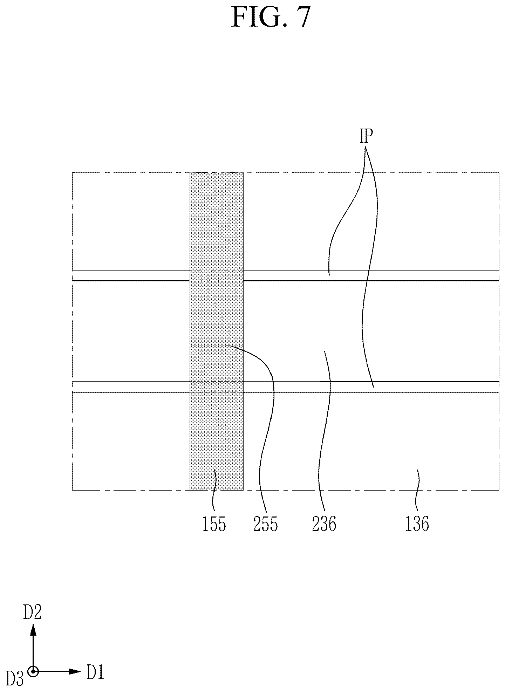

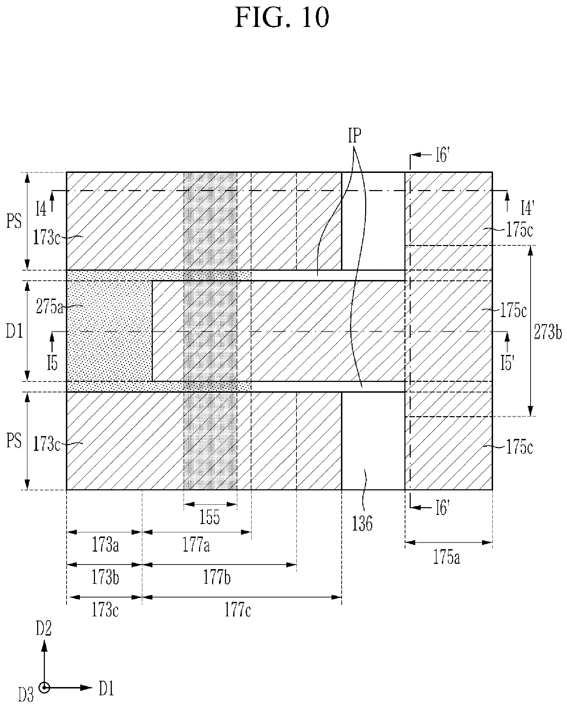

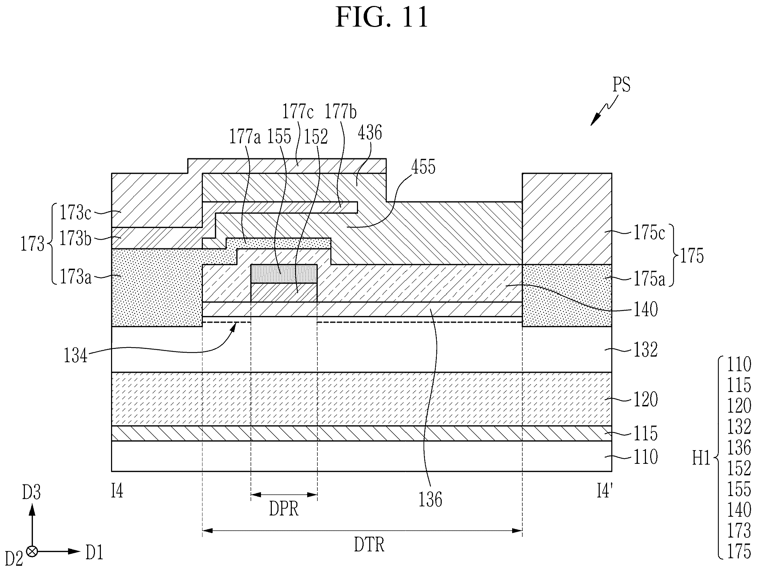

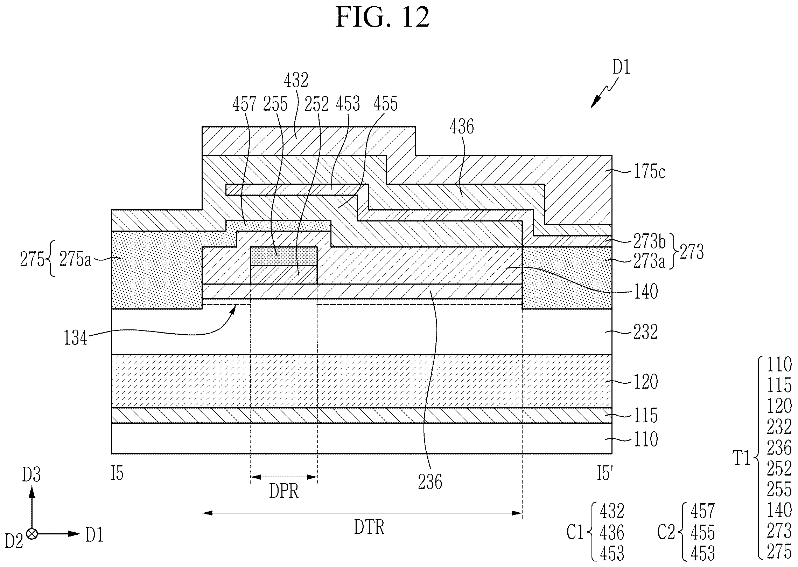

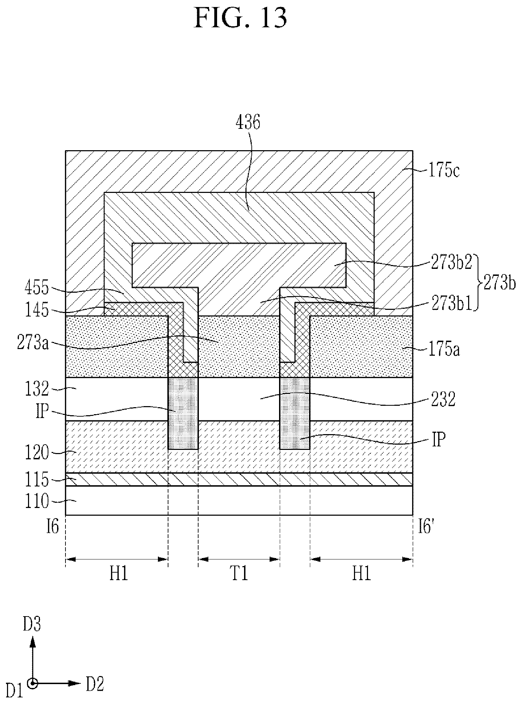

FIGS. 7 to 10 are plan views showing a semiconductor device according to an embodiment. FIG. 11 is a cross-sectional view taken along line I4-I4' of FIG. 10. FIG. 12 is a cross-sectional view taken along line I5-I5' of FIG. 10. FIG. 13 is a cross-sectional view taken along line I6-I6' of FIG. 10.

For clear understanding and simplified illustration, FIG. 7 mainly shows the main barrier layer 136 and the main gate electrode 155 of the main transistor H1, and the reset barrier layer 236 and the reset gate electrode 255 of the reset transistor T1.

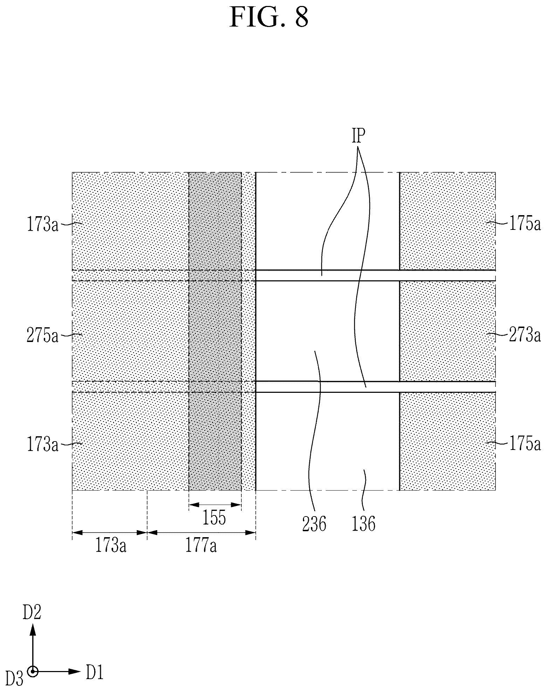

FIG. 8 mainly shows the lower main source electrode 173a, lower main drain electrode 175a, and first main field dispersion layer 177a of the main transistor H1, and the lower first reset electrode 275a and the lower second reset electrode 273a of the reset transistor T1.

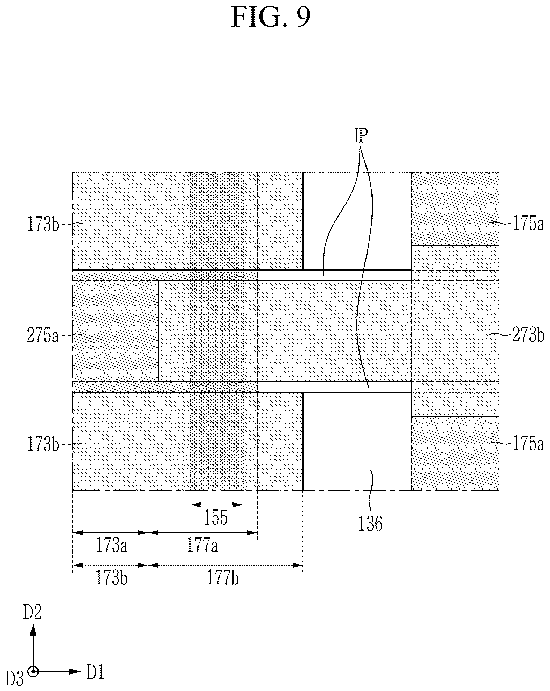

In FIG. 9, the middle main source electrode 173b and the second main field dispersion layer 177b of the main transistor H1 are mainly shown, and the middle second reset electrode 273b of the reset transistor T1 is mainly shown.

FIG. 10 mainly shows the upper main source electrode 173c and the upper main drain electrode 175c of the main transistor H1.

Referring to FIGS. 1 and 7 to 13, the semiconductor device may include a power semiconductor PS and a voltage divider D1 connected to the power semiconductor PS.

As an example, the power semiconductor PS and the voltage divider D1 may be located in the main device region. The power semiconductor PS and the voltage divider D1 may be located on one substrate. The power semiconductor PS and the voltage divider D1 may be arranged to be spaced apart in the second direction D2 with the separation pattern IP interposed therebetween.

The power semiconductor PS may include a main transistor H1. As an example, the main transistor H1 may be a gallium nitride-based high electron mobility transistor (HEMT). The voltage divider D1 may include a plurality of capacitors C1 and C2, a voltage output unit Vᵥₛ connected between the plurality of capacitors C1 and C2, and a reset transistor T1 connected to the voltage output unit Vᵥₛ.

For example, the main transistor H1 and the reset transistor T1 may be arranged to be spaced apart in the second direction D2 with the separation pattern IP interposed therebetween. A plurality of capacitors C1 and C2 may be located on the main transistor H1 and the reset transistor T1 in the third direction D3. However, the present disclosure is not limited thereto. For example, the plurality of capacitors C1 and C2 may be located in the peripheral circuit region and may be connected to the main transistor H1 and the reset transistor T1 through a metal wire.

The main transistor H1 may include the main channel layer 132, the main barrier layer 136 on the main channel layer 132, the main gate electrode 155 on the main barrier layer 136, a main gate semiconductor layer 152 between the main barrier layer 136 and the main gate electrode 155, and the main source electrode 173 and the main drain electrode 175 spaced apart from the main gate electrode 155.

Since the description of the main transistor H1 shown in FIG. 11 is substantially the same as the embodiment shown in FIG. 5, the description thereof will be omitted and the differences will be mainly explained.

In FIG. 11, the main source electrode 173 may include the lower main source electrode 173a, the middle main source electrode 173b, and the upper main source electrode 173c. The middle main source electrode 173b may be located on the lower main source electrode 173a. The upper main source electrode 173c may be located on the middle main source electrode 173b. In an embodiment, the lower main source electrode 173a is in direct contact with the main channel layer 132 and may be electrically connected to the main channel layer 132. In an embodiment, the middle main source electrode 173b and the upper main source electrode 173c are not in direct contact with the main channel layer 132, and may be electrically connected to the main channel layer 132 through the lower main source electrode 173a.

The main drain electrode 175 may include the lower main drain electrode 175a and the upper main drain electrode 175c. The upper main drain electrode 175c may be located on the lower main drain electrode 175a. In an embodiment, the lower main drain electrode 175a is in direct contact with the main channel layer 132 and may be electrically connected to the main channel layer 132. In an embodiment, the upper main drain electrode 175c is not in direct contact with the main channel layer 132, and may be electrically connected to the main channel layer 132 through the lower main drain electrode 175a.

The main transistor H1 may further include a first field dispersion layer 177a located on the first protective layer 140. The first field dispersion layer 177a may be located between the main source electrode 173 and the main drain electrode 175. The first field dispersion layer 177a may overlap with the main gate electrode 155 in the third direction D3. The main gate electrode 155 may be covered by the first field dispersion layer 177a. The first field dispersion layer 177a may be electrically connected to the main source electrode 173. For example, the first field dispersion layer 177a may be connected to the lower main source electrode 173a. The first field dispersion layer 177a may include a same material as the lower main source electrode 173a and may be located in a same layer as the lower main source electrode 173a. The first field dispersion layer 177a may be formed simultaneously with the lower main source electrode 173a using a same process. The boundary between the first field dispersion layer 177a and the lower main source electrode 173a may be indistinct, and thus the first field dispersion layer 177a may be formed integrally with the lower main source electrode 173a. However, the present disclosure is not limited thereto, and the first field dispersion layer 177a may be a separate component separated from the lower main source electrode 173a. Additionally, the first field dispersion layer 177a may be located in a different layer from the lower main source electrode 173a and may be formed in a different process. In some cases, the first field dispersion layer 177a may be electrically connected to the main gate electrode 155. For example, an opening that is overlapped with the main gate electrode 155 may be formed in the first protective layer 140, and the first field dispersion layer 177a may be connected to the main gate electrode 155 through the opening. In an embodiment, the first field dispersion layer 177a is not connected to the main source electrode 173.

The main transistor H1 may further include a second field dispersion layer 177b located on the second dielectric 455. The second field dispersion layer 177b may form a field dispersion layer together with the first field dispersion layer 177a. The second field dispersion layer 177b may be located between the main source electrode 173 and the main drain electrode 175. The second field dispersion layer 177b may overlap with the main gate electrode 155 in the third direction D3. The second field dispersion layer 177b may overlap with the first field dispersion layer 177a in the third direction D3. The main gate electrode 155 and the first field dispersion layer 177a may be covered by the second field dispersion layer 177b. In an embodiment, the second field dispersion layer 177b is wider than the first field dispersion layer 177a. For example, the second field dispersion layer 177b may be wider than the first field dispersion layer 177a in the first direction D1. The second field dispersion layer 177b may entirely cover the first field dispersion layer 177a. However, the present disclosure is not limited thereto, and the width and positional relationship of the first field dispersion layer 177a and the second field dispersion layer 177b may be changed in various ways. The second field dispersion layer 177b may be electrically connected to the main source electrode 173. For example, the second field dispersion layer 177b may be connected to the middle main source electrode 173b. The second field dispersion layer 177b may include a same material as the middle main source electrode 173b and may be located in a same layer as the middle main source electrode 173b. The second field dispersion layer 177b may be formed simultaneously with the middle main source electrode 173b using a same process. The boundary between the second field dispersion layer 177b and the middle main source electrode 173b may be indistinct, and thus the second field dispersion layer 177b may be formed integrally with the middle main source electrode 173b. However, the present disclosure is not limited thereto. For example, the second field dispersion layer 177b may be a separate component separated from the middle main source electrode 173b. Additionally, the second field dispersion layer 177b may be located in a different layer from the middle main source electrode 173b and may be formed in a different process.

The main transistor H1 may further include a third field dispersion layer 177c located on the first dielectric 436. The third field dispersion layer 177c may form a field dispersion layer together with the first field dispersion layer 177a and the second field dispersion layer 177b. The third field dispersion layer 177c may be located between the main source electrode 173 and the main drain electrode 175. The third field dispersion layer 177c may overlap with the main gate electrode 155 in the third direction D3. The third field dispersion layer 177c may overlap with the first field dispersion layer 177a and the second field dispersion layer 177b in the third direction D3. The main gate electrode 155, the first field dispersion layer 177a, and the second field dispersion layer 177b may be covered by the third field dispersion layer 177c. In an embodiment, the third field dispersion layer 177c is wider than the second field dispersion layer 177b. For example, the third field dispersion layer 177c may be wider than the second field dispersion layer 177b in the third direction D3. The third field dispersion layer 177c may entirely cover the second field dispersion layer 177b. However, the present disclosure is not limited thereto, and the width and positional relationship of the first field dispersion layer 177a, the second field dispersion layer 177b, and the third field dispersion layer 177c may be changed in various ways. The third field dispersion layer 177c may be electrically connected to the main source electrode 173. For example, the third field dispersion layer 177c may be connected to the upper main source electrode 173c. The third field dispersion layer 177c may include a same material as the upper main source electrode 173c and may be located in the same layer as the upper main source electrode 173c. The third field dispersion layer 177c may be formed simultaneously using a same process as the upper main source electrode 173c. The boundary between the third field dispersion layer 177c and the upper main source electrode 173c may be indistinct, and thus the third field dispersion layer 177c may be formed integrally with the upper main source electrode 173c. However, the present disclosure is not limited thereto. For example, the third field dispersion layer 177c may be a separate component separated from the upper main source electrode 173c. Additionally, the third field dispersion layer 177c may be located in a different layer from the upper main source electrode 173c and may be formed in a different process.

In some embodiments, at least one of the first field dispersion layer 177a, the second field dispersion layer 177b, or the third field dispersion layer 177c may be omitted. For example, the main transistor H1 may include the first field dispersion layer 177a and may not include the second field dispersion layer 177b or the third field dispersion layer 177c. Alternatively, the main transistor H1 may include the second field dispersion layer 177b and not include the first field dispersion layer 177a or the third field dispersion layer 177c. Alternatively, the main transistor H1 may include the third field dispersion layer 177c and not include the first field dispersion layer 177a or the second field dispersion layer 177b. Alternatively, the main transistor H1 may not include the first field dispersion layer 177a, the second field dispersion layer 177b, and the third field dispersion layer 177c.

The voltage divider D1 may include a reset transistor T1 and a plurality of capacitors C1 and C2 located on one side of the reset transistor T1.

The reset transistor T1 may include the reset channel layer 232, the reset barrier layer 236 on the reset channel layer 232, the reset gate electrode 255 on the reset barrier layer 236, the reset gate semiconductor layer 252 between a reset barrier layer 236 and the reset gate electrode 155, and the first reset electrode 275 and the second reset electrode 273 on both sides of the reset gate electrode 255.

Since the description of the reset transistor T1 shown in FIG. 12 is substantially the same as the embodiment shown in FIG. 6, the description thereof will be omitted and the differences will be mainly explained.

The main channel layer 132 and the reset channel layer 232 may be separated from each other by the separation pattern IP shown in FIGS. 10 and 13. That is, the positions of the main channel layer 132 and the reset channel layer 232 on the substrate 110 may be defined by the separation pattern IP.

The separation pattern IP may be located between the main channel layer 132 and the reset channel layer 232. The separation pattern IP may extend along the first direction D1 and may extend, for example, along the first direction D1 from the lower portion of the main drain electrode 175 through the lower portion of the main gate electrode 155 to the lower portion of the main source electrode 173. Additionally, the separation pattern IP may extend along the first direction D1 from the lower portion of the second reset electrode 273 through the bottom of the reset gate electrode 255 to the lower portion of the first reset electrode 275. However, embodiments of the present disclosure are not limited thereto. For example, the separation pattern IP may extend only from the lower portion of the main drain electrode 175 to the lower portion of the main gate electrode 155, and may not be located under the main source electrode 173, and may extend only from the lower portion of the second reset electrode 273 to the lower portion of the reset gate electrode 255, and may not be located under the first reset electrode 275.

There may be a plurality of separation patterns IP, and the plurality of separation patterns IP may be spaced apart from one another in the second direction D2. In an embodiment, the reset transistor T1 is located between the plurality of spaced apart separation patterns IP, and the main transistor H1 is located on both sides of the reset transistor T1.

The separation pattern IP can be formed by injecting a material such as Ar using an ion implantation (IIP) method while a channel material layer is formed on the buffer layer.

The reset barrier layer 236 may be located on the reset channel layer 232. In an embodiment, the reset barrier layer 236 is located directly on the reset channel layer 232. However, embodiments of the present disclosure are not limited thereto. For example, another layer may be further located between the reset channel layer 232 and the reset barrier layer 236.

The reset barrier layer 236 may be formed simultaneously with the main barrier layer 136 of the main transistor H1 using a same process. The reset barrier layer 236 may include the same material as the main barrier layer 136.

The reset gate electrode 255 may be located on the reset barrier layer 236. The reset gate electrode 255 may overlap with a portion of the reset barrier layer 236. The reset gate electrode 255 may overlap with a portion of the drift region of the reset channel layer 232. The reset gate electrode 255 may be located between the second reset electrode 273 and the first reset electrode 275. The reset gate electrode 255 may be spaced apart from the first reset electrode 275 and the second reset electrode 273. The reset gate electrode 255 may extend along the second direction D2 on a plane. That is, the reset gate electrode 255 may have a rod shape extending lengthwise along the second direction D2 on a plane.

The reset gate electrode 255 may be electrically connected to the main gate electrode 155 of the main transistor H1. The reset gate electrode 255 may include the same material as the main gate electrode 155 and may be located in a same layer as the main gate electrode 155. The reset gate electrode 255 may be formed simultaneously with the main gate electrode 155 using a same process. The boundary between the reset gate electrode 255 and the main gate electrode 155 may be indistinct, and thus the reset gate electrode 255 may be formed integrally with the main gate electrode 155.

At this time, the reset gate electrode 255 and the main gate electrode 155 may be distinguished by a separation pattern IP. For example, a separation pattern IP may be located between the main channel layer 132 and the reset channel layer 232, the main gate electrode 155 may be located on the main channel layer 132, and the reset gate electrode 255 may be located on the reset channel layer 232.

However, embodiments of the present disclosure are not limited thereto. For example, the reset gate electrode 255 may be a separate component from the main gate electrode 155. Additionally, the reset gate electrode 255 may be located in a different layer from the main gate electrode 155 and may be formed in a different process. However, in this case, the reset gate electrode 255 and the main gate electrode 155 may be connected by a metal wire or the like.

When the reset gate electrode 255 and the main gate electrode 155 are electrically connected, the charge accumulated in the voltage output unit Vᵥₛ during a turn-on operation escapes through the main source electrode 173 of the main transistor H1, and thus it is automatically reset to 0 V, and the voltage can be distributed to V_{D}C₁/(C₁+C₂) during a turn-off operation. In this way, since the voltage output unit Vᵥₛ is not floating, a voltage shift due to leakage current can be prevented.

The first reset electrode 275 and the second reset electrode 273 may be located on the reset channel layer 232. The first reset electrode 275 and the second reset electrode 273 may be spaced apart from each other, and the reset gate electrode 255 and the reset gate semiconductor layer 252 may be located between the second reset electrode 273 and the first reset electrode 275. The reset gate electrode 255 and the reset gate semiconductor layer 252 may be spaced apart from the first reset electrode 275 and the second reset electrode 273. The second reset electrode 273 may be electrically connected to the reset channel layer 232 on one side of the reset gate electrode 255 and may be connected to the voltage output unit Vᵥₛ. The first reset electrode 275 may be electrically connected to the reset channel layer 232 on the other side of the reset gate electrode 255.

A drift region DTR may be located in a partial area of the reset channel layer 232 between the second reset electrode 273 and the first reset electrode 275. In an embodiment, the first reset electrode 275 and the second reset electrode 273 are located outside the drift region of the reset channel layer 232. That is, the first reset electrode 275 and the second reset electrode 273 extend into the reset channel layer 232, and a portion of the side surface may be in contact with the reset channel layer 232. The drift region may be located between a portion of the side surface of the second reset electrode 273 in contact with the reset channel layer 232 and a portion of the side surface of the first reset electrode 275 in contact with the reset channel layer 232. However, embodiments of the present disclosure are not limited thereto. For example, the first reset electrode 275 and the second reset electrode 273 may not be located outside the drift region DTR of the reset channel layer 232 in other embodiments. In an embodiment, the reset channel layer 232 is not recessed, and the first reset electrode 275 and the second reset electrode 273 may be located on the upper surface of the reset channel layer 232. In an embodiment, bottom surfaces of the first reset electrode 275 and the second reset electrode 273 contact an upper surface of the main channel layer 132. A portion of the main channel layer 132 in contact with the first reset electrode 275 and the second reset electrode 273 may be doped at a high concentration.

The first reset electrode 275 may include a lower first reset electrode 275a. In an embodiment, the lower first reset electrode 275a is in direct contact with the reset channel layer 232 and may be electrically connected to the reset channel layer 232.

The lower first reset electrode 275a may be electrically connected to the main source electrode 173. For example, the lower first reset electrode 275a may be connected to the lower main source electrode 173a. The lower first reset electrode 275a may include the same material as the lower main source electrode 173a and may be located in a same layer as the lower main source electrode 173a. The lower first reset electrode 275a may be formed simultaneously with the lower main source electrode 173a using a same process. The boundary between the lower first reset electrode 275a and the lower main source electrode 173a may be indistinct, and thus the lower first reset electrode 275a may be formed integrally with the lower main source electrode 173a. However, embodiments of the present disclosure are not limited thereto. For example, the lower first reset electrode 275a may be a separate component separated from the lower main source electrode 173a. Additionally, the lower first reset electrode 275a may be located in a different layer from the lower main source electrode 173a and may be formed in a different process.

At this time, the lower first reset electrode 275a and the lower main source electrode 173a may be distinguished by a separation pattern IP. For example, a separation pattern IP may be located between the main channel layer 132 and the reset channel layer 232, and the lower main source electrode 173a may be located on the main channel layer 132, and the lower first reset electrode 275a may be located on the reset channel layer 232.

The second reset electrode 273 may include a lower second reset electrode 273a and a middle second reset electrode 273b. The middle second reset electrode 273b may be located on the lower second reset electrode 273a. In an embodiment, the lower second reset electrode 273a is in direct contact with the reset channel layer 232 and may be electrically connected to the reset channel layer 232. In an embodiment, the middle second reset electrode 273b is not in direct contact with the reset channel layer 232, and may be electrically connected to the reset channel layer 232 through the lower second reset electrode 273a.

The lower second reset electrode 273a may include the same material as the lower main drain electrode 175a and may be located in a same layer as the lower main drain electrode 175a. The lower second reset electrode 273a may be formed simultaneously with the lower main drain electrode 175a using a same process.

However, the lower main drain electrode 175a and the lower second reset electrode 273a may be spaced apart from one another in the second direction D2 and not connected to one another. For example, a separation pattern IP may be located between the main channel layer 132 and the reset channel layer 232, and the lower main drain electrode 175a may be located on the main channel layer 132, and the lower second reset electrode 273a may be located on the reset channel layer 232. Additionally, the first dielectric 436 may be located between the spaced apart lower main drain electrode 175a and the lower second reset electrode 273a. At this time, the first dielectric 436 between the lower main drain electrode 175a and the lower second reset electrode 273a may be located on the separation pattern IP.

Additionally, the lower second reset electrode 273a may include the same material as the lower first reset electrode 275a and may be located in a same layer as the lower first reset electrode 275a. The lower second reset electrode 273a may be formed simultaneously with the lower first reset electrode 275a using a same process. However, the lower second reset electrode 273a and the lower first reset electrode 275a may be spaced apart from one another in the first direction D1 and not connected to one another.

The middle second reset electrode 273b may include the same material as the middle main source electrode 173a and may be located in a same layer as the middle main source electrode 173a. The middle second reset electrode 273b may be formed simultaneously with the middle main source electrode 173a using a same process.

However, the middle second reset electrode 273b and the middle main source electrode 173a may be spaced apart from one another in the first direction D1 and the second direction D2 and may not be connected to one another. For example, the main gate electrode 155 and the reset gate electrode 255 may be located between the middle second reset electrode 273b and the middle main source electrode 173a in the first direction D1, the separation pattern IP may be located between the main channel layer 132 and the reset channel layer 232 in the second direction D2, the middle main source electrode 173a may be located on the main channel layer 132, and the middle second reset electrode 273b may be located on the reset channel layer 232.

In addition, the middle second reset electrode 273b may be located on the lower second reset electrode 273a, and may have a vertical portion 273b1 extending in the third direction D3, and a horizontal portion 273b2 located on the vertical portion 273b1 and extending in the second direction D2. In an embodiment, a width of the horizontal portion 273b2 of the middle second reset electrode 273b in the second direction D2 is larger than a width of the vertical portion 273b1 in the second direction D2. Additionally, in an embodiment, the width of the horizontal portion 273b2 of the middle second reset electrode 273b in the second direction D2 is larger than the width of the lower second reset electrode 273a in the second direction D2. Accordingly, at least a portion of the horizontal portion 273b2 of the middle second reset electrode 273b may be also located on the lower main drain electrode 175a. However, the horizontal portion 273b2 of the middle second reset electrode 273b and the lower main drain electrode 175a do not contact one another but are spaced apart from one another. For example, the fourth protective layer 145 and the second dielectric 455 may be located between the horizontal portion 273b2 of the middle second reset electrode 273b and the lower main drain electrode 175a.

Additionally, the fourth protective layer 145 and the second dielectric 455 may be located on both sides of the lower second reset electrode 273a in the second direction D2. For example, the fourth protective layer 145 and the second dielectric 455 may be located between the lower second reset electrode 273a and the lower main drain electrode 175a. The fourth protective layer 145 may be located between the second dielectric 455 and the lower main drain electrode 175a. The fourth protective layer 145 may prevent the second dielectric 455 and the lower main drain electrode 175a from being electrically connected. Due to the fourth protective layer 145, the second capacitor C2 including the second dielectric 455 is not connected to the main drain electrode 175.

The fourth protective layer 145 may include an insulating material. For example, the fourth protective layer 145 may include an oxide such as SiO₂ or Al₂O₃. As another example, the fourth protective layer 145 may include a nitride such as SiN or an oxynitride such as SiON. The fourth protective layer 145 may include a same material as or may include a different material from the first to third protective layers 140, 150, and 160. If the fourth protective layer 145 and the first to third protective layers 140, 150, and 160 are made of the same material, the fourth protective layer 145 and the first to third protective layers 140, 150, and 160 may not be visible. The fourth protective layer 145 may be formed separately from the first to third protective layers 140, 150, and 160 in a different process, or may be formed together in the same process. The fourth protective layer 145 may be made of a single layer or multiple layers.

Additionally, the first dielectric 436 may be located on both sides and upper surface of the middle second reset electrode 273b in the second direction D2. For example, the first dielectric 436 may be located on both sides of the vertical portion 273b1 of the middle second reset electrode 273b in the second direction D2 and may be located on both sides and upper surface of the horizontal portion 273b2 of the middle second reset electrode 273b in the second direction D2. Accordingly, the first dielectric 436 may surround at least a portion of the middle second reset electrode 273b.

Meanwhile, the upper main drain electrode 175c may be located on the middle second reset electrode 273b. However, the upper main drain electrode 175c and the middle second reset electrode 273b are not in contact with one another but are spaced apart from one another. For example, the first dielectric 436 may be located between the upper main drain electrode 175c and the middle second reset electrode 273b.

Additionally, the upper main drain electrode 175c may be located on both sides of the middle second reset electrode 273b in the second direction D2. Accordingly, the upper main drain electrode 175c may surround at least a portion of the middle second reset electrode 273b. However, even at this time, the upper main drain electrode 175c and the middle second reset electrode 273b do not contact one another but are spaced apart from one another. For example, the first dielectric 436 may be located between the upper main drain electrode 175c and the middle second reset electrode 273b.

The first and second capacitors C1 and C2 may be located on the reset transistor T1 in the third direction D3.

As an example, the first capacitor C1 may include a second capacitor electrode 453, a first capacitor electrode 432 located on the second capacitor electrode 453 and overlapped with the second capacitor electrode 453 in the third direction D3, and a first dielectric 436 located between the first capacitor electrode 432 and the second capacitor electrode 453 and overlapped with the first capacitor electrode 432 and the second capacitor electrode 453 in the third direction D3.

The second capacitor C2 may include a third capacitor electrode 457, a second capacitor electrode 453 located on the third capacitor electrode 457 and overlapped with the third capacitor electrode 457 in the third direction D3, and a second dielectric 455 located between the third capacitor electrode 457 and the second capacitor electrode 453 and overlapped with the third capacitor electrode 457 and the second capacitor electrode 453 in the third direction D3.

The third capacitor electrode 457 is located on the first protective layer 140. The third capacitor electrode 457 may be located between the first reset electrode 275 and the second reset electrode 273. The third capacitor electrode 457 may overlap with the reset gate electrode 255 in the third direction D3. The reset gate electrode 255 may be covered by the third capacitor electrode 457. The third capacitor electrode 457 may be electrically connected to the first reset electrode 275. For example, the third capacitor electrode 457 may be connected to the lower first reset electrode 275a. The third capacitor electrode 457 may include a same material as the lower first reset electrode 275a and may be located in a same layer as the lower first reset electrode 275a. The third capacitor electrode 457 may be formed simultaneously with the lower first reset electrode 275a using a same process. The boundary between the third capacitor electrode 457 and the lower first reset electrode 275a may be indistinct, and thus the third capacitor electrode 457 may be formed integrally with the lower first reset electrode 275a. However, embodiments of the present disclosure are not limited thereto. For example, the third capacitor electrode 457 may be a separate component separated from the lower first reset electrode 275a. Additionally, the third capacitor electrode 457 may be located in a different layer from the lower first reset electrode 275a and may be formed in a different process.

The second dielectric 455 may be located on the third capacitor electrode 457. In an embodiment, the second dielectric 455 has a lower surface in contact with the upper surface of the third capacitor electrode 457 and an upper surface in contact with the lower surface of the second capacitor electrode 453. The second dielectric 455 may include an insulating material. In an embodiment, the second dielectric 455 may be SiN_{X} (0<x≤2). However, embodiments of the present disclosure are not limited thereto. For example, the second dielectric 455 may include various types of insulating materials that can insulate between the third capacitor electrode 457 and the second capacitor electrode 453. For example, the second dielectric 455 may include an insulating material such as SiO₂, Al₂O₃, SiN, or SiON, or a combination thereof.

The second capacitor electrode 453 is located on the second dielectric 455. The second capacitor electrode 453 may form a second capacitor C2 together with the third capacitor electrode 457 and the second dielectric 455. The second capacitor electrode 453 may be located between the first reset electrode 275 and the second reset electrode 273. The second capacitor electrode 453 may overlap with the reset gate electrode 255 in the third direction D3. The second capacitor electrode 453 may overlap with the third capacitor electrode 457 in the third direction D3. The reset gate electrode 255 and the third capacitor electrode 457 may be covered by the second capacitor electrode 453. In an embodiment, the second capacitor electrode 453 is wider than the third capacitor electrode 457. The second capacitor electrode 453 may entirely cover the third capacitor electrode 457. However, embodiments of the present disclosure are not limited thereto, and a width and positional relationship of the second capacitor electrode 453 and the third capacitor electrode 457 may be changed in various ways. The second capacitor electrode 453 may be electrically connected to the second reset electrode 273. For example, the second capacitor electrode 453 may be connected to the middle second reset electrode 273b. The second capacitor electrode 453 may include a same material as the middle second reset electrode 273b and may be located in the same layer as the middle second reset electrode 273b. The second capacitor electrode 453 may be formed simultaneously with the second middle reset electrode 273b using a same process. The boundary between the second capacitor electrode 453 and the middle second reset electrode 273b may be indistinct, and thus the second capacitor electrode 453 may be formed integrally with the middle second reset electrode 273b. However, embodiments of the present disclosure are not limited thereto. For example, the second capacitor electrode 453 may be a separate component separated from the middle second reset electrode 273b. Additionally, the second capacitor electrode 453 may be located in a different layer from the middle second reset electrode 273b and may be formed in a different process.

Meanwhile, the second capacitor electrode 453 may include a same material as the second field dispersion layer 177b and may be located in a same layer as the second field dispersion layer 177b. The second capacitor electrode 453 may be formed simultaneously with the second field dispersion layer 177b using a same process. However, the second capacitor electrode 453 and the second field dispersion layer 177b may be spaced apart from one another in the second direction D2 and not connected to one another. That is, the second capacitor electrode 453 and the second field dispersion layer 177b can be distinguished by the separation pattern IP. For example, a separation pattern IP may be located between the main channel layer 132 and the reset channel layer 232, and the second field dispersion layer 177b may be located on the main channel layer 132, and the second capacitor electrode 453 may be located on the reset channel layer 232.

The first dielectric 436 may be located on the second capacitor electrode 453. In an embodiment, the first dielectric 436 has a lower surface in contact with an upper surface of the second capacitor electrode 453 and an upper surface in contact with the lower surface of the first capacitor electrode 432. The first dielectric 436 may include an insulating material. As an example, the first dielectric 436 may be SiN_{X} (0<x≤2). However, embodiments of the present disclosure are not limited thereto. For example, the first dielectric 436 may include various types of insulating materials that can insulate between the second capacitor electrode 453 and the first capacitor electrode 432. For example, the first dielectric 436 may include an insulating material such as SiO₂, Al₂O₃, SiN, or SiON, or a combination thereof.

The first capacitor electrode 432 may be located on the first dielectric 436. The first capacitor electrode 432 may form the first capacitor C1 together with the second capacitor electrode 453 and the first dielectric 436. The first capacitor electrode 432 may be located between the first reset electrode 275 and the second reset electrode 273. The first capacitor electrode 432 may overlap with the reset gate electrode 255 in the third direction D3. The first capacitor electrode 432 may overlap with the second capacitor electrode 453 and the third capacitor electrode 457 in the third direction D3. The reset gate electrode 255, the second capacitor electrode 453, and the third capacitor electrode 457 may be covered by the first capacitor electrode 432. In an embodiment, the first capacitor electrode 432 is wider than the second capacitor electrode 453. The first capacitor electrode 432 may entirely cover the second capacitor electrode 453. However, embodiments of the present disclosure are not limited thereto. For example, the width and positional relationship of the first capacitor electrode 432 and the second capacitor electrode 453 may be changed in various ways. The first capacitor electrode 432 may be electrically connected to the main drain electrode 175. For example, the first capacitor electrode 432 may be connected to the upper main drain electrode 175c. The first capacitor electrode 432 may include a same material as the upper main drain electrode 175c and may be located in a same layer as the upper main drain electrode 175c. The first capacitor electrode 432 may be formed simultaneously with the upper main drain electrode 175c using a same process. The boundary between the first capacitor electrode 432 and the upper main drain electrode 175c may be indistinct, and thus the first capacitor electrode 432 may be formed integrally with the upper first reset electrode 275c. However, embodiments of the present disclosure are not limited thereto. For example, the first capacitor electrode 432 may be a separate component separated from the upper main drain electrode 175c. Additionally, the first capacitor electrode 432 may be located in a different layer from the upper main drain electrode 175c and may be formed in a different process.

As described above, since the second capacitor electrode 453 of the first capacitor C1 is connected to the middle second reset electrode 273b, one end of the first capacitor C1 is connected to the second reset electrode 273, and since the first capacitor electrode 432 of the first capacitor C1 is connected to the upper main drain electrode 175c, the other end of the first capacitor C1 may be connected to the main drain electrode 175.

Additionally, since the third capacitor electrode 457 of the second capacitor C2 is connected to the upper first reset electrode 275a, one end of the second capacitor C2 may be connected to the main source electrode 173, and since the second capacitor electrode 453 of the second capacitor C2 is connected to the middle second reset electrode 273b, the other end of the second capacitor C2 may be connected to the second reset electrode 273.

For example, the second capacitor C2 may have a larger capacitance than the first capacitor C1. That is, the capacitance of the second capacitor C2 connected to the main source electrode 173 of the main transistor H1 may be larger than the first capacitor C1 connected to the main drain electrode 175 of the main transistor H1. Accordingly, the first capacitor C1 should withstand a high voltage, so that it may be an inter metallic dielectric (IMD) capacitor in which the first dielectric 436 has a thicker thickness, and the second capacitor C2 should have a large capacitance, so that it may be a thin MIM (Metal-Insulator-Metal) capacitor. However, embodiments of the present disclosure are not limited thereto. The capacitance of the first capacitor C1 and the second capacitor C2 can be adjusted by the length and width of the metal wire and the thickness of the dielectric.

## Claims

1. A semiconductor device, comprising
a power semiconductor including a main transistor (H1); and
a voltage divider (D1) connected to the power semiconductor and including a plurality of capacitors (C1, C2), a voltage output circuit (Vvs) connected between the plurality of capacitors (C1, C2), and a reset transistor (T1) connected to the voltage output circuit (Vvs),
wherein a main gate electrode (155), which is a gate electrode of the main transistor (H1), is connected to a reset gate electrode (255), which is a gate electrode of the reset transistor (T1), wherein
the main transistor (H1) includes a main drain electrode (175) receiving a first power voltage, and a main source electrode (173) receiving a second power voltage,
the reset transistor (T1) includes a first reset electrode (275) connected to the main source electrode (173), and a second reset electrode (273) connected to the voltage output circuit (VVS), and
wherein the plurality of capacitors (C1, C2) comprises:
a first capacitor (C1) having a first end connected to the main drain electrode (175) and a second end connected to the voltage output circuit (VVS) through a first node, and
a second capacitor (C2) having a first end connected to the voltage output circuit (VVS) and the second end of the first capacitor (C1) through a first node, and a second end connected to the main source electrode (173) through a second node, and
wherein the first reset electrode (275) of the reset transistor (T1) is connected to the second end of the second capacitor (C2) through the second node.

2. The semiconductor device of claim 1, wherein the second capacitor (C2) has a larger capacitance than the first capacitor (C1).

3. The semiconductor device of claim 2, wherein
the second reset electrode (273) of the reset transistor (T1) is connected to the voltage output circuit (Vvs) and the first node through a third node.

4. The semiconductor device of claim 1, wherein:
the main transistor (H1) comprises:
a main channel layer (132);
a main barrier layer (136) on the main channel layer (132); and
a main source electrode (173) and a main drain electrode (175) connected to the main channel layer (132),
the reset transistor (T1) comprises:
a reset channel layer (232) spaced apart from the main channel layer (132);
a reset barrier layer (236) on the reset channel layer (232); and
a first reset electrode (275) and a second reset electrode (273) which are connected to the reset channel layer (232) the main gate electrode (155) is on the main barrier layer (136),
and the reset gate electrode (255) is on the reset barrier layer (236).

5. The semiconductor device of claim 4, wherein the plurality of capacitors (C1, C2) comprises:
the second end of the first capacitor (C1) is connected to the second reset electrode (273), and the first end of the second capacitor (C2) is connected to the second reset electrode (273).

6. The semiconductor device of claim 5, wherein the first capacitor (C1) comprises:
a first capacitor electrode (432) connected to the main drain electrode (175);
a second capacitor electrode (453) overlapping the first capacitor electrode (432) and connected to the second reset electrode (273); and
a first dielectric (436) located between the first capacitor electrode (432) and the second capacitor electrode (453),
wherein the second capacitor (C2) comprises:
the second capacitor electrode (453) connected to the second reset electrode (273);
a third capacitor electrode (457) overlapping the second capacitor electrode (453) and connected to the main source electrode (173); and
a second dielectric (455) located between the second capacitor electrode (453) and the third capacitor electrode (457), and
wherein the semiconductor device further includes a separation pattern located between the main channel layer (132) and the reset channel layer (232), and extending in a first direction,
the main gate electrode (155) and the reset gate electrode (255) are formed integrally, and
the main gate electrode (155) located on the main channel layer (132) and the reset gate electrode (255) located on the reset channel layer (232) are divided by the separation pattern.

7. The semiconductor device of claim 4 or 5, wherein
the semiconductor device further includes a separation pattern (IP) located between the main channel layer (132) and the reset channel layer (232), and extending in a first direction,
the main source electrode(173) and the first reset electrode (275) are connected to each other across the separation pattern (IP),
one end of the separation pattern (IP) is located in a lower portion between the main source electrode (173) and the first reset electrode (275), and one end of the separation pattern (IP) passes through one side of the first reset electrode (275) in a plane without passing through another side of the first reset electrode (275).

8. The semiconductor device of claim 1,
wherein the main transistor (H1) comprises:
a main channel layer (132);
a main barrier layer (136) on the main channel layer (132); and
a main source electrode (173) and a main drain electrode (175) connected to the main channel layer (132),
wherein the reset transistor (T1) comprises:
a reset channel layer (232) spaced apart from the main channel layer (132) in a second direction different from the first direction by a separation pattern (IP) extending in the first direction;
a reset barrier layer (236) on the reset channel layer (232);
a first reset electrode (275) connected to the reset channel layer (232) and connected to the main source electrode (173); and
a second reset electrode (273) connected to the reset channel layer (232),
wherein the main gate electrode (155) is on the main barrier layer (136), and
wherein the reset gate electrode (255) is on the reset barrier layer (236).

9. The semiconductor device of claim 8, wherein:
the main gate electrode (155) and the reset gate electrode (255) are formed integrally, and
the main gate electrode (155) located on the main channel layer (132) and the reset gate electrode (255) located on the reset channel layer (232) are divided by the separation pattern (IP).

10. The semiconductor device of claim 8 or 9, wherein:
the main source electrode (173) includes a lower main source electrode (173a), a middle main source electrode (173b), and an upper main source electrode (173c),
the first reset electrode (275) includes a lower first reset electrode (275a),
the lower main source electrode (173a) and the lower first reset electrode (275a) are connected to each other, and are divided into the lower main source electrode (173a) on the main channel layer (132) and the lower first reset electrode (275a) on the reset channel layer (232) by the separation pattern (IP),
the main drain electrode (175) includes a lower main drain electrode (175a) and an upper main drain electrode (175c),
the second reset electrode (273) includes a lower second reset electrode (273a) and a middle second reset electrode (273b),
the lower main drain electrode (175a) and the lower second reset electrode (273a) are located in a same layer, and the lower main drain electrode (175a) and the lower second reset electrode (273a) are spaced apart in the second direction,
the middle second reset electrode (273b) is on the lower second reset electrode (273a),
the upper main drain electrode (175c) is on the lower main drain electrode (175a), and
the upper main drain electrode (175c) is spaced apart from the middle second reset electrode (273b) and is on the middle second reset electrode (273b).

11. The semiconductor device of claim 10, wherein the main transistor (H1) comprises:
a first field dispersion layer connected to the lower main source electrode (173a);
a second field dispersion layer connected to the middle main source electrode (173b); and
a third field dispersion layer connected to the upper main source electrode (173c), and
wherein the plurality of capacitors (C1, C2) comprise:
a first capacitor (C1) having a first end connected to the main drain electrode (175) and a second end connected to the second reset electrode (273); and
a second capacitor (C2) having a first end connected to the second reset electrode (273) and the second end of the first capacitor (C1), and a second end connected to the main source electrode (173),
wherein the first capacitor (C1) includes a second capacitor electrode (453) connected to the middle second reset electrode (273b), a first capacitor electrode (432) connected to the upper main drain electrode (175), and a first dielectric (436) between the second capacitor electrode (453) and the first capacitor electrode (432), and
the second capacitor (C2) includes a third capacitor electrode (457) connected to the lower main source electrode (173a), the second capacitor electrode (453), and a second dielectric (455) between the third capacitor electrode (457) and the second capacitor electrode (453).

12. The semiconductor device of claim 11, wherein
the second dielectric (455) is located between the lower main drain electrode (175a) and the lower second reset electrode (273a) spaced apart in the second direction, and
a protective layer (140) is between the second dielectric (455) and the lower main drain electrode (175a).

13. The semiconductor device of claim 11 or 12, wherein
the first dielectric (436) surrounds both sides and upper surface of the middle second reset electrode (273b) in the second direction, and
the upper main drain electrode (175c) surrounds both sides and upper surface of the first dielectric (436) in the second direction.

14. The semiconductor device of any one of claims 11 to 13, wherein
the middle second reset electrode (273b) is located on the lower second reset electrode (273a), has a vertical portion extending in a third direction different from the first direction and the second direction, and a horizontal portion located on the vertical portion and extending in the second direction, and
the horizontal portion is located on the lower main drain electrode (175a) with the second dielectric (455) interposed therebetween.

15. The semiconductor device according to claim 1, wherein
the power semiconductor is located in a main device region,
the voltage divider (D1) is located in a peripheral circuit region located on one side of the main device region,
the main transistor (H1) includes a main channel layer (132), a main barrier layer (136) on the main channel layer (132), a main gate electrode (155) on the main barrier layer (136), and a main source electrode (173) and a main drain electrode (175) which are connected to the main channel layer (132),
the reset transistor (T1) includes a reset channel layer (232) spaced apart from the main channel layer (132), a reset barrier layer (236) on the reset channel layer (232), a reset gate electrode (255) on the reset barrier layer (236), and a first reset electrode (275) and a second reset electrode (273) which are connected to the reset channel layer (232).

## Patentansprüche

1. Halbleiterbauelement, aufweisend:
einen Leistungshalbleiter, der einen Haupttransistor (H1) enthält; und
einen Spannungsteiler (D1), der mit dem Leistungshalbleiter verbunden ist und mehrere Kondensatoren (C1, C2), eine zwischen den mehreren Kondensatoren (C1, C2) geschaltete Spannungsausgangsschaltung (V_{VS}) und einen mit der Spannungsausgangsschaltung (V_{VS}) verbundenen Rücksetztransistor (T1) enthält,
wobei eine Haupt-Gate-Elektrode (155), die eine Gate-Elektrode des Haupttransistors (H1) ist, mit einer Rücksetz-Gate-Elektrode (255) verbunden ist, die eine Gate-Elektrode des Rücksetztransistors (T1) ist, wobei der Haupttransistor (H1) eine Haupt-Drain-Elektrode (175), die eine erste Versorgungsspannung empfängt, und eine Haupt-Source-Elektrode (173), die eine zweite Versorgungsspannung empfängt, umfasst,
der Rücksetztransistor (T1) eine erste Rücksetzelektrode (275), die mit der Haupt-Source-Elektrode (173) verbunden ist, und eine zweite Rücksetzelektrode (273), die mit der Spannungsausgangsschaltung (VVS) verbunden ist, umfasst und
wobei die mehreren Kondensatoren (C1, C2) aufweisen:
einen ersten Kondensator (C1), dessen erstes Ende mit der Haupt-Drain-Elektrode (175) verbunden ist und dessen zweites Ende über einen ersten Knoten mit der Spannungsausgangsschaltung (VVS) verbunden ist, und
einen zweiten Kondensator (C2), dessen erstes Ende über einen ersten Knoten mit der Spannungsausgangsschaltung (VVS) und dem zweiten Ende des ersten Kondensators (C1) verbunden ist, und dessen zweites Ende über einen zweiten Knoten mit der Haupt-Source-Elektrode (173) verbunden ist, und
wobei die erste Rücksetzelektrode (275) des Rücksetztransistors (T1) über den zweiten Knoten mit dem zweiten Ende des zweiten Kondensators (C2) verbunden ist.

2. Halbleiterbauelement nach Anspruch 1, wobei der zweite Kondensator (C2) eine größere Kapazität als der erste Kondensator (C1) aufweist.

3. Halbleiterbauelement nach Anspruch 2, wobei
die zweite Rücksetzelektrode (273) des Rücksetztransistors (T1) über einen dritten Knoten mit der Spannungsausgangsschaltung (V_{VS}) und dem ersten Knoten verbunden ist.

4. Halbleiterbauelement nach Anspruch 1, wobei:
der Haupttransistor (H1) aufweist:
eine Hauptkanalschicht (132);
eine Hauptbarriereschicht (136) auf der Hauptkanalschicht (132); und
eine Haupt-Source-Elektrode (173) und eine Haupt-Drain-Elektrode (175), die mit der Hauptkanalschicht (132) verbunden sind,
der Rücksetztransistor (T1) aufweist:
eine Rücksetz-Kanalschicht (232), die von der Hauptkanalschicht (132) beabstandet ist;
eine Rücksetz-Barriereschicht (236) auf der Rücksetz-Kanalschicht (232); und
eine erste Rücksetzelektrode (275) und eine zweite Rücksetzelektrode (273), die mit der Rücksetz-Kanalschicht (232) verbunden sind, wobei die Haupt-Gate-Elektrode (155) sich auf der Hauptbarriereschicht (136) befindet,
und die Rücksetz-Gate-Elektrode (255) sich auf der Rücksetz-Barriereschicht (236) befindet.

5. Halbleiterbauelement nach Anspruch 4, wobei bei den mehreren Kondensatoren (C1, C2) das zweite Ende des ersten Kondensators (C1) mit der zweiten Rücksetzelektrode (273) verbunden ist und das erste Ende des zweiten Kondensators (C2), das mit der zweiten Rücksetzelektrode (273) verbunden ist.

6. Halbleiterbauelement nach Anspruch 5, wobei der erste Kondensator (C1) aufweist:
eine erste Kondensatorelektrode (432), die mit der Haupt-Drain-Elektrode (175) verbunden ist;
eine zweite Kondensatorelektrode (453), die die erste Kondensatorelektrode (432) überlappt und mit der zweiten Rücksetzelektrode (273) verbunden ist; sowie ein erstes Dielektrikum (436), das sich zwischen der ersten Kondensatorelektrode (432) und der zweiten Kondensatorelektrode (453) befindet,
wobei der zweite Kondensator (C2) aufweist:
die zweite Kondensatorelektrode (453), die mit der zweiten Rücksetzelektrode (273) verbunden ist;
eine dritte Kondensatorelektrode (457), die die zweite Kondensatorelektrode (453) überlappt und mit der Haupt-Source-Elektrode (173) verbunden ist; sowie
ein zweites Dielektrikum (455), das sich zwischen der zweiten Kondensatorelektrode (453) und der dritten Kondensatorelektrode (457) befindet, und
wobei das Halbleiterbauelement ferner ein Trennmuster umfasst, das sich zwischen der Hauptkanalschicht (132) und der Rücksetz-Kanalschicht (232) befindet und sich in einer ersten Richtung erstreckt,
die Haupt-Gate-Elektrode (155) und die Rücksetz-Gate-Elektrode (255) einstückig ausgebildet sind, und
die auf der Hauptkanalschicht (132) angeordnete Haupt-Gate-Elektrode (155) und die auf der Rücksetz-Kanalschicht (232) angeordnete Rücksetz-Gate-Elektrode (255) durch das Trennmuster getrennt sind.

7. Halbleiterbauelement nach Anspruch 4 oder 5, wobei
das Halbleiterbauelement ferner ein Trennmuster (IP) umfasst, das sich zwischen der Hauptkanalschicht (132) und der Rücksetz-Kanalschicht (232) befindet und sich in einer ersten Richtung erstreckt,
die Haupt-Source-Elektrode (173) und die erste Rücksetzelektrode (275) über das Trennmuster (IP) hinweg miteinander verbunden sind,
ein Ende des Trennmusters (IP) in einem unteren Abschnitt zwischen der Haupt-Source-Elektrode (173) und der ersten Rücksetzelektrode (275) angeordnet ist und ein Ende des Trennmusters (IP) in einer Ebene durch eine Seite der ersten Rücksetzelektrode (275) verläuft, ohne durch eine andere Seite der ersten Rücksetzelektrode (275) zu verlaufen.

8. Halbleiterbauelement nach Anspruch 1,
wobei der Haupttransistor (H1) aufweist:
eine Hauptkanalschicht (132);
eine Hauptbarriereschicht (136) auf der Hauptkanalschicht (132); und
eine Haupt-Source-Elektrode (173) und eine Haupt-Drain-Elektrode (175), die mit der Hauptkanalschicht (132) verbunden sind,
wobei der Rücksetztransistor (T1) aufweist:
eine Rücksetz-Kanalschicht (232), die von der Hauptkanalschicht (132) in einer zweiten Richtung, die sich von der ersten Richtung unterscheidet, durch ein sich in der ersten Richtung erstreckendes Trennmuster (IP) beabstandet ist;
eine Rücksetz-Barriereschicht (236) auf der Rücksetz-Kanalschicht (232);
eine erste Rücksetzelektrode (275), die mit der Rücksetz-Kanalschicht (232) verbunden ist und mit der Haupt-Source-Elektrode (173) verbunden ist; und
eine zweite Rücksetzelektrode (273), die mit der Rücksetzkanalschicht (232) verbunden ist,
wobei sich die Haupt-Gate-Elektrode (155) auf der Hauptbarriereschicht (136) befindet und
wobei sich die Rücksetz-Gate-Elektrode (255) auf der Rücksetz-Barriereschicht (236) befindet.

9. Halbleiterbauelement nach Anspruch 8, wobei:
die Haupt-Gate-Elektrode (155) und die Rücksetz-Gate-Elektrode (255) einstückig ausgebildet sind, und
die auf der Hauptkanalschicht (132) befindliche Haupt-Gate-Elektrode (155) und die auf der Rücksetz-Kanalschicht (232) befindliche Rücksetz-Gate-Elektrode (255) durch das Trennmuster (IP) voneinander getrennt sind.

10. Halbleiterbauelement nach Anspruch 8 oder 9, wobei:
die Haupt-Source-Elektrode (173) eine untere Haupt-Source-Elektrode (173a), eine mittlere Haupt-Source-Elektrode (173b) und eine obere Haupt-Source-Elektrode (173c) umfasst,
die erste Rücksetzelektrode (275) eine untere erste Rücksetzelektrode (275a) umfasst,
die untere Haupt-Source-Elektrode (173a) und die untere erste Rücksetzelektrode (275a) miteinander verbunden sind und durch das Trennmuster (IP) in die untere Haupt-Source-Elektrode (173a) auf der Hauptkanalschicht (132) und die untere erste Rücksetzelektrode (275a) auf der Rücksetz-Kanalschicht (232) unterteilt sind,
die Haupt-Drain-Elektrode (175) eine untere Haupt-Drain-Elektrode (175a) und eine obere Haupt-Drain-Elektrode (175c) umfasst,
die zweite Rücksetzelektrode (273) eine untere zweite Rücksetzelektrode (273a) und eine mittlere zweite Rücksetzelektrode (273b) umfasst,
die untere Haupt-Drain-Elektrode (175a) und die untere zweite Rücksetzelektrode (273a) in derselben Schicht angeordnet sind, und die untere Haupt-Drain-Elektrode (175a) und die untere zweite Rücksetzelektrode (273a) in der zweiten Richtung voneinander beabstandet sind,
die mittlere zweite Rücksetzelektrode (273b) sich auf der unteren zweiten Rücksetzelektrode (273a) befindet,
die obere Haupt-Drain-Elektrode (175c) sich auf der unteren Haupt-Drain-Elektrode (175a) befindet, und
die obere Haupt-Drain-Elektrode (175c) von der mittleren zweiten Rücksetzelektrode (273b) beabstandet ist und sich auf der mittleren zweiten Rücksetzelektrode (273b) befindet.

11. Halbleiterbauelement nach Anspruch 10, wobei der Haupttransistor (H1) aufweist:
eine erste Feldverteilungsschicht, die mit der unteren Haupt-Source-Elektrode (173a) verbunden ist;
eine zweite Feldverteilungsschicht, die mit der mittleren Haupt-Source-Elektrode (173b) verbunden ist; und
eine dritte Feldverteilungsschicht, die mit der oberen Haupt-Source-Elektrode (173c) verbunden ist, und
wobei die mehreren Kondensatoren (C1, C2) aufweisen:
einen ersten Kondensator (C1), dessen erstes Ende mit der Haupt-Drain-Elektrode (175) verbunden ist und dessen zweites Ende mit der zweiten Rücksetzelektrode (273) verbunden ist; und
einen zweiten Kondensator (C2), dessen erstes Ende mit der zweiten Rücksetzelektrode (273) und dem zweiten Ende des ersten Kondensators (C1) verbunden ist und dessen zweites Ende mit der Haupt-Source-Elektrode (173) verbunden ist,
wobei der erste Kondensator (C1) eine zweite Kondensatorelektrode (453), die mit der mittleren zweiten Rücksetzelektrode (273b) verbunden ist, eine erste Kondensatorelektrode (432), die mit der oberen Haupt-Drain-Elektrode (175) verbunden ist, und ein erstes Dielektrikum (436) zwischen der zweiten Kondensatorelektrode (453) und der ersten Kondensatorelektrode (432) umfasst, und
der zweite Kondensator (C2) eine dritte Kondensatorelektrode (457), die mit der unteren Haupt-Source-Elektrode (173a) verbunden ist, die zweite Kondensatorelektrode (453) und ein zweites Dielektrikum (455) zwischen der dritten Kondensatorelektrode (457) und der zweiten Kondensatorelektrode (453) umfasst.

12. Halbleiterbauelement nach Anspruch 11, wobei
das zweite Dielektrikum (455) zwischen der unteren Haupt-Drain-Elektrode (175a) und der unteren zweiten Rücksetzelektrode (273a) angeordnet ist, die in der zweiten Richtung voneinander beabstandet sind, und
sich eine Schutzschicht (140) zwischen dem zweiten Dielektrikum (455) und der unteren Haupt-Drain-Elektrode (175a) befindet.

13. Halbleiterbauelement nach Anspruch 11 oder 12, wobei
das erste Dielektrikum (436) beide Seiten und die obere Oberfläche der mittleren zweiten Rücksetzelektrode (273b) in der zweiten Richtung umgibt, und
die obere Haupt-Drain-Elektrode (175c) beide Seiten und eine obere Oberfläche des ersten Dielektrikums (436) in der zweiten Richtung umgibt.

14. Halbleiterbauelement nach einem der Ansprüche 11 bis 13, wobei
die mittlere zweite Rücksetzelektrode (273b) auf der unteren zweiten Rücksetzelektrode (273a) angeordnet ist, einen vertikalen Abschnitt aufweist, der sich in einer dritten Richtung erstreckt, die sich von der ersten Richtung und der zweiten Richtung unterscheidet, sowie einen horizontalen Abschnitt, der auf dem vertikalen Abschnitt angeordnet ist und sich in der zweiten Richtung erstreckt, und
der horizontale Abschnitt auf der unteren Haupt-Drain-Elektrode (175a) angeordnet ist, wobei das zweite Dielektrikum (455) dazwischen angeordnet ist.

15. Halbleiterbauelement nach Anspruch 1, wobei
der Leistungshalbleiter in einem Hauptbauelementbereich angeordnet ist,
der Spannungsteiler (D1) in einem Peripherieschaltungsbereich angeordnet ist, der sich auf einer Seite des Hauptbauelementbereichs befindet,
der Haupttransistor (H1) eine Hauptkanalschicht (132), eine Hauptbarriereschicht (136) auf der Hauptkanalschicht (132), eine Haupt-Gate-Elektrode (155) auf der Hauptbarriereschicht (136) sowie eine Haupt-Source-Elektrode (173) und eine Haupt-Drain-Elektrode (175) umfasst, die mit der Hauptkanalschicht (132) verbunden sind,
der Rücksetztransistor (T1) eine von der Hauptkanalschicht (132) beabstandete Rücksetz-Kanalschicht (232), eine Rücksetz-Barriereschicht (236) auf der Rücksetz-Kanalschicht (232), eine Rücksetz-Gate-Elektrode (255) auf der Rücksetz-Barriereschicht (236) sowie eine erste Rücksetzelektrode (275) und eine zweite Rücksetzelektrode (273) umfasst, die mit der Rücksetz-Kanalschicht (232) verbunden sind.

## Revendications

1. Dispositif à semi-conducteur, comprenant :
un semi-conducteur de puissance comprenant un transistor principal (H1) ; et
un diviseur de tension (D1) relié au semi-conducteur de puissance et comprenant une pluralité de condensateurs (C1, C2), un circuit de sortie de tension (VVS) relié entre les condensateurs de la pluralité de condensateurs (C1, C2), et un transistor de réinitialisation (T1) relié au circuit de sortie de tension (VVS),
dans lequel une électrode de grille principale (155), qui est une électrode de grille du transistor principal (H1), est reliée à une électrode de grille de réinitialisation (255), qui est une électrode de grille du transistor de réinitialisation (T1), dans lequel
le transistor principal (H1) comprend une électrode de drain principale (175) recevant une première tension d'alimentation, et une électrode de source principale (173) recevant une deuxième tension d'alimentation,
le transistor de réinitialisation (T1) comprend une première électrode de réinitialisation (275) reliée à l'électrode de source principale (173), et une deuxième électrode de réinitialisation (273) reliée au circuit de sortie de tension (VVS), et
dans lequel la pluralité de condensateurs (C1, C2) comprend :
un premier condensateur (C1) ayant une première extrémité reliée à l'électrode de drain principale (175) et une deuxième extrémité reliée au circuit de sortie de tension (VVS) par l'intermédiaire d'un premier nœud, et
un deuxième condensateur (C2) ayant une première extrémité reliée au circuit de sortie de tension (VVS) et à la deuxième extrémité du premier condensateur (C1) par l'intermédiaire d'un premier nœud, et une deuxième extrémité reliée à l'électrode de source principale (173) par l'intermédiaire d'un deuxième nœud, et
dans lequel la première électrode de réinitialisation (275) du transistor de réinitialisation (T1) est reliée à la deuxième extrémité du deuxième condensateur (C2) par l'intermédiaire du deuxième nœud.

2. Dispositif à semi-conducteur selon la revendication 1, dans lequel le deuxième condensateur (C2) présente une capacité supérieure à celle du premier condensateur (C1).

3. Dispositif à semi-conducteur selon la revendication 2, dans lequel
la deuxième électrode de réinitialisation (273) du transistor de réinitialisation (T1) est reliée au circuit de sortie de tension (VVS) et au premier nœud par l'intermédiaire d'un troisième nœud.

4. Dispositif à semi-conducteur selon la revendication 1, dans lequel :
le transistor principal (H1) comprend :
une couche de canal principale (132) ;
une couche barrière principale (136) sur la couche de canal principale (132) ; et
une électrode de source principale (173) et une électrode de drain principale (175) reliées à la couche de canal principale (132),
le transistor de réinitialisation (T1) comprend :
une couche de canal de réinitialisation (232) espacée de la couche de canal principale (132) ;
une couche barrière de réinitialisation (236) sur la couche de canal de réinitialisation (232) ; et
une première électrode de réinitialisation (275) et une deuxième électrode de réinitialisation (273) qui sont reliées à la couche de canal de réinitialisation (232),
l'électrode de grille principale (155) est sur la couche barrière principale (136),
et l'électrode de grille de réinitialisation (255) est sur la couche barrière de réinitialisation (236).

5. Dispositif à semi-conducteur selon la revendication 4, dans lequel, dans la pluralité de condensateurs (C1, C2) :
la deuxième extrémité du premier condensateur (C1) est reliée à la deuxième électrode de réinitialisation (273), et la première extrémité du deuxième condensateur (C2) est reliée à la deuxième électrode de réinitialisation (273).

6. Dispositif à semi-conducteur selon la revendication 5, dans lequel le premier condensateur (C1) comprend :
une première électrode de condensateur (432) reliée à l'électrode de drain principale (175) ;
une deuxième électrode de condensateur (453) chevauchant la première électrode de condensateur (432) et reliée à la deuxième électrode de réinitialisation (273) ; et
un premier diélectrique (436) situé entre la première électrode de condensateur (432) et la deuxième électrode de condensateur (453),
dans lequel le deuxième condensateur (C2) comprend :
la deuxième électrode de condensateur (453) reliée à la deuxième électrode de réinitialisation (273) ;
une troisième électrode de condensateur (457) chevauchant la deuxième électrode de condensateur (453) et reliée à l'électrode de source principale (173) ; et
un deuxième diélectrique (455) situé entre la deuxième électrode de condensateur (453) et la troisième électrode de condensateur (457), et
dans lequel le dispositif à semi-conducteur comprend en outre un motif de séparation situé entre la couche de canal principale (132) et la couche de canal de réinitialisation (232), et s'étendant dans une première direction,
l'électrode de grille principale (155) et l'électrode de grille de réinitialisation (255) sont formées d'un seul tenant, et
l'électrode de grille principale (155) située sur la couche de canal principale (132) et l'électrode de grille de réinitialisation (255) située sur la couche de canal de réinitialisation (232) sont séparées par le motif de séparation.

7. Dispositif à semi-conducteur selon la revendication 4 ou 5, dans lequel
le dispositif à semi-conducteur comprend en outre un motif de séparation (IP) situé entre la couche de canal principale (132) et la couche de canal de réinitialisation (232), et s'étendant dans une première direction,
l'électrode de source principale (173) et la première électrode de réinitialisation (275) sont reliées l'une à l'autre en franchissant le motif de séparation (IP),
une extrémité du motif de séparation (IP) est située dans une partie inférieure entre l'électrode de source principale (173) et la première électrode de réinitialisation (275), et ladite extrémité du motif de séparation (IP) traverse, en vue en plan, un côté de la première électrode de réinitialisation (275) sans traverser un autre côté de la première électrode de réinitialisation (275).

8. Dispositif à semi-conducteur selon la revendication 1,
dans lequel le transistor principal (H1) comprend :
une couche de canal principale (132) ;
une couche barrière principale (136) sur la couche de canal principale (132) ; et
une électrode de source principale (173) et une électrode de drain principale (175) reliées à la couche de canal principale (132),
dans lequel le transistor de réinitialisation (T1) comprend :
une couche de canal de réinitialisation (232) espacée de la couche de canal principale (132), dans une deuxième direction différente de la première direction, par un motif de séparation (IP) s'étendant dans la première direction ;
une couche barrière de réinitialisation (236) sur la couche de canal de réinitialisation (232) ;
une première électrode de réinitialisation (275) reliée à la couche de canal de réinitialisation (232) et reliée à l'électrode de source principale (173) ; et
une deuxième électrode de réinitialisation (273) reliée à la couche de canal de réinitialisation (232),
dans lequel l'électrode de grille principale (155) est sur la couche barrière principale (136), et
dans lequel l'électrode de grille de réinitialisation (255) est sur la couche barrière de réinitialisation (236).

9. Dispositif à semi-conducteur selon la revendication 8, dans lequel :
l'électrode de grille principale (155) et l'électrode de grille de réinitialisation (255) sont formées d'un seul tenant, et
l'électrode de grille principale (155) située sur la couche de canal principale (132) et l'électrode de grille de réinitialisation (255) située sur la couche de canal de réinitialisation (232) sont séparées par le motif de séparation (IP).

10. Dispositif à semi-conducteur selon la revendication 8 ou 9, dans lequel :
l'électrode de source principale (173) comprend une électrode de source principale inférieure (173a), une électrode de source principale intermédiaire (173b) et une électrode de source principale supérieure (173c),
la première électrode de réinitialisation (275) comprend une première électrode de réinitialisation inférieure (275a),
l'électrode de source principale inférieure (173a) et la première électrode de réinitialisation inférieure (275a) sont reliées l'une à l'autre, et sont séparées, par le motif de séparation (IP), en l'électrode de source principale inférieure (173a) sur la couche de canal principale (132) et la première électrode de réinitialisation inférieure (275a) sur la couche de canal de réinitialisation (232),
l'électrode de drain principale (175) comprend une électrode de drain principale inférieure (175a) et une électrode de drain principale supérieure (175c),
la deuxième électrode de réinitialisation (273) comprend une deuxième électrode de réinitialisation inférieure (273a) et une deuxième électrode de réinitialisation intermédiaire (273b),
l'électrode de drain principale inférieure (175a) et la deuxième électrode de réinitialisation inférieure (273a) sont situées dans une même couche, et l'électrode de drain principale inférieure (175a) et la deuxième électrode de réinitialisation inférieure (273a) sont espacées l'une de l'autre dans la deuxième direction,
la deuxième électrode de réinitialisation intermédiaire (273b) est sur la deuxième électrode de réinitialisation inférieure (273a),
l'électrode de drain principale supérieure (175c) est sur l'électrode de drain principale inférieure (175a), et
l'électrode de drain principale supérieure (175c) est espacée de la deuxième électrode de réinitialisation intermédiaire (273b) et est sur la deuxième électrode de réinitialisation intermédiaire (273b).

11. Dispositif à semi-conducteur selon la revendication 10, dans lequel le transistor principal (H1) comprend :
une première couche de dispersion de champ reliée à l'électrode de source principale inférieure (173a) ;
une deuxième couche de dispersion de champ reliée à l'électrode de source principale intermédiaire (173b) ; et
une troisième couche de dispersion de champ reliée à l'électrode de source principale supérieure (173c), et
dans lequel la pluralité de condensateurs (C1, C2) comprend :
un premier condensateur (C1) ayant une première extrémité reliée à l'électrode de drain principale (175) et une deuxième extrémité reliée à la deuxième électrode de réinitialisation (273) ; et
un deuxième condensateur (C2) ayant une première extrémité reliée à la deuxième électrode de réinitialisation (273) et à la deuxième extrémité du premier condensateur (C1), et une deuxième extrémité reliée à l'électrode de source principale (173),
dans lequel le premier condensateur (C1) comprend une deuxième électrode de condensateur (453) reliée à la deuxième électrode de réinitialisation intermédiaire (273b), une première électrode de condensateur (432) reliée à l'électrode de drain principale supérieure (175), et un premier diélectrique (436) entre la deuxième électrode de condensateur (453) et la première électrode de condensateur (432), et
le deuxième condensateur (C2) comprend une troisième électrode de condensateur (457) reliée à l'électrode de source principale inférieure (173a), la deuxième électrode de condensateur (453), et un deuxième diélectrique (455) entre la troisième électrode de condensateur (457) et la deuxième électrode de condensateur (453).

12. Dispositif à semi-conducteur selon la revendication 11, dans lequel
le deuxième diélectrique (455) est situé entre l'électrode de drain principale inférieure (175a) et la deuxième électrode de réinitialisation inférieure (273a) espacées l'une de l'autre dans la deuxième direction, et
une couche de protection (140) est située entre le deuxième diélectrique (455) et l'électrode de drain principale inférieure (175a).

13. Dispositif à semi-conducteur selon la revendication 11 ou 12, dans lequel
le premier diélectrique (436) entoure les deux côtés et la surface supérieure de la deuxième électrode de réinitialisation intermédiaire (273b) dans la deuxième direction, et
l'électrode de drain principale supérieure (175c) entoure les deux côtés et la surface supérieure du premier diélectrique (436) dans la deuxième direction.

14. Dispositif à semi-conducteur selon l'une quelconque des revendications 11 à 13, dans lequel
la deuxième électrode de réinitialisation intermédiaire (273b) est située sur la deuxième électrode de réinitialisation inférieure (273a), présente une partie verticale s'étendant dans une troisième direction différente de la première direction et de la deuxième direction, et une partie horizontale située sur la partie verticale et s'étendant dans la deuxième direction, et
la partie horizontale est située sur l'électrode de drain principale inférieure (175a), le deuxième diélectrique (455) étant interposé entre elles.

15. Dispositif à semi-conducteur selon la revendication 1, dans lequel
le semi-conducteur de puissance est situé dans une région de dispositif principal,
le diviseur de tension (D1) est situé dans une région de circuit périphérique située sur un côté de la région de dispositif principal,
le transistor principal (H1) comprend une couche de canal principale (132), une couche barrière principale (136) sur la couche de canal principale (132), une électrode de grille principale (155) sur la couche barrière principale (136), et une électrode de source principale (173) et une électrode de drain principale (175) qui sont reliées à la couche de canal principale (132),
le transistor de réinitialisation (T1) comprend une couche de canal de réinitialisation (232) espacée de la couche de canal principale (132), une couche barrière de réinitialisation (236) sur la couche de canal de réinitialisation (232), une électrode de grille de réinitialisation (255) sur la couche barrière de réinitialisation (236), et une première électrode de réinitialisation (275) et une deuxième électrode de réinitialisation (273) qui sont reliées à la couche de canal de réinitialisation (232).
